# EUROPEAN PATENT APPLICATION

(11) **EP 4 657 781 A1**
(43) Date of publication of application: **03.12.2025**
(21) Application number: 24756021.2
(22) Date of filing: 01.02.2024
(51) Int. Cl.: H04L 1/00

(54) **JOINT SOURCE-CHANNEL CODING METHOD AND SYSTEM**

(30) Priority: 14.02.2023 CN 202310149145; 12.05.2023 CN 202310532479
(71) Applicant: Huawei Technologies Co., Ltd., Shenzhen, Guangdong 518129 (CN)
(72) Inventor: WANG, Bichai, Shenzhen, Guangdong 518129 (CN); DOU, Fenghui, Shenzhen, Guangdong 518129 (CN); ZHANG, Yanqing, Shenzhen, Guangdong 518129 (CN); LI, Xueru, Shenzhen, Guangdong 518129 (CN)
(74) Representative: Thun, Clemens
(86) International application number: PCT/CN2024/075325
(87) International publication number: WO 2024/169647

(57) **Abstract**

This application discloses a joint source-channel encoding method and an information exchange method that are used during wireless data transmission. In the method, through information exchange between an access network, a core network, and a server, the access network can perform joint source-channel encoding on service data, and the access network can further jointly optimize a source-channel encoding parameter with reference to a channel condition, to adapt to different channel conditions of a terminal in real time, so that transmission efficiency of data during wireless transmission is high.

## Description

This application claims priorities to Chinese Patent Application No. 202310149145.7, filed with the China National Intellectual Property Administration on February 14, 2023 and entitled "COMMUNICATION METHOD AND DEVICE", and to Chinese Patent Application No. 202310532479.2, filed with the China National Intellectual Property Administration on May 12, 2023 and entitled "JOINT SOURCE-CHANNEL ENCODING METHOD AND SYSTEM", both of which are incorporated herein by reference in their entireties.

### TECHNICAL FIELD

This application relates to an encoding method, and in particular, to a joint source-channel encoding method and a system.

### BACKGROUND

During conventional data transmission, source encoding and channel encoding are two independent modules. The source encoding is processed at an application layer, and the channel encoding is processed at a physical layer. A coding rate in the channel encoding may be adjusted based on a channel condition. However, an encoding parameter for the source encoding is not adjusted in real time based on channel quality. As a result, when a channel condition is poor, data reception quality rapidly deteriorates, and a frame freezing or mosaic phenomenon occurs. To improve the data reception quality, a joint source-channel encoding scheme is proposed in the industry, to be specific, entropy encoding and channel encoding in a video encoder are jointly performed. Compared with conventional separate source-channel encoding, joint source-channel encoding has better adaptability to different channel conditions and has a larger encoding gain.

Nowadays, watching a video online via a wireless terminal such as a mobile phone or a tablet has become a part of people's daily life. Therefore, it is urgent to improve transmission efficiency of service data in a wireless environment.

### SUMMARY

During wireless transmission, joint source-channel encoding is performed on service data. An existing wireless transmission protocol stack cannot provide support, for example, an interface or information exchange, for the joint source-channel encoding. To resolve the foregoing technical problem, this application provides a communication method, a system (which may also be referred to as a communication system), a communication apparatus, a computer-readable storage medium, a chip, and the like.

According to a first aspect, the method is applied to a system. The system includes a first device, a second device, and a third device, and the method includes:

The third device sends first information to the second device, where the first information indicates the second device to perform joint source-channel encoding.

The third device sends first data to the second device.

The second device performs joint source-channel encoding on the first data, and sends second data to the first device, where the second data is data obtained by performing joint source-channel encoding on the first data.

According to the first aspect, before the third device sends the first data to the second device, the method further includes: The third device receives third data from a server, where the third data is associated with the first data.

According to any one of the first aspect or the implementations of the first aspect, before the second device performs joint source-channel encoding on the first data, the method further includes:

The second device determines a third parameter based on at least one of a first parameter and a second parameter, where the third parameter is used by the second device to perform joint source-channel encoding on the first data.

The first parameter includes at least one of the following: a type of a source encoder, a rate-distortion mapping model of an I-frame, a rate-distortion mapping model of a P-frame, a rate-distortion mapping model of a B-frame, a size of a group of pictures (group of pictures, GOP), a type of each frame in the GOP, a quantity of slices in each frame, a length of each slice, a motion vector for predictive encoding, a source entropy rate, or processing delay information of the source encoder.

The second parameter indicates channel quality information between the second device and the first device.

The second device performs joint source-channel encoding on the first data based on the third parameter.

According to any one of the first aspect or the implementations of the first aspect,
the third parameter includes at least one of the following: a source quantization parameter, a coding rate in source encoding, a code length in source encoding, a base matrix in source encoding, a coding rate in channel encoding, a code length in channel encoding, or a base matrix in channel encoding.

According to any one of the first aspect or the implementations of the first aspect, the method further includes:

The third device sends the first parameter to the second device.

Alternatively, the second device receives the second parameter from the first device.

According to any one of the first aspect or the implementations of the first aspect, before the third device sends the first parameter to the second device, the method further includes: The third device receives the first parameter from the server.

According to any one of the first aspect or the implementations of the first aspect, the method further includes: The third device receives a fourth parameter from the server, where the fourth parameter is used by the third device to perform source decoding on the third data.

After the third device receives the third data from the server, and before the third device sends the first data to the second device, the method further includes:

The third device performs source decoding on the third data based on the fourth parameter, where the first data is data obtained by performing source decoding on the third data.

According to any one of the first aspect or the implementations of the first aspect, the fourth parameter includes at least one of the following: a type of a source encoder, a code length in source encoding, a coding rate in source encoding, a source entropy rate, an encryption parameter, or a decryption parameter.

According to any one of the first aspect or the implementations of the first aspect, the third device sends third information to the first device, where the third information indicates the first device to perform at least one of joint source-channel encoding, joint source-channel decoding, and source encoding.

According to any one of the first aspect or the implementations of the first aspect, the third device performs source decoding on the second data at a first protocol layer.

According to any one of the first aspect or the implementations of the first aspect, the first protocol layer is a protocol data unit PDU layer, or the first protocol layer is located below the PDU layer.

According to any one of the first aspect or the implementations of the first aspect, a packet header corresponding to the first protocol layer includes the fourth parameter.

According to any one of the first aspect or the implementations of the first aspect, before the third device sends the first information to the second device, the method includes:

The third device receives first capability information from the second device and second capability information from a first device, where the first capability information indicates at least one of a joint source-channel encoding capability, a joint source-channel decoding capability, or a joint source-channel coding capability of the second device, and the second capability information indicates at least one of a joint source-channel encoding capability, a joint source-channel decoding capability, or a joint source-channel coding capability of the first device.

According to any one of the first aspect or the implementations of the first aspect, before the third device sends the first information to the second device, the method includes:

The third device receives the first capability information from the second device.

According to any one of the first aspect or the implementations of the first aspect, before the third device sends the first information to the second device, the method includes: The third device receives the second capability information from the first device.

According to any one of the first aspect or the implementations of the first aspect, the method includes:

The third device sends the first capability information to the server.

According to any one of the first aspect or the implementations of the first aspect, the method includes:

The third device sends the second capability information to the server.

According to any one of the first aspect or the implementations of the first aspect, the first capability information and the second capability information are located in different messages or in a same message.

According to any one of the first aspect or the implementations of the first aspect, that the third device sends the first information is determined based on at least one of the first capability information and the second capability information.

According to any one of the first aspect or the implementations of the first aspect, the third data is the same as the first data.

According to any one of the first aspect or the implementations of the first aspect, the third device includes a policy control function PCF network element, a session management function SMF network element, an access management function AMF network element, and a user plane function UPF network element.

That the third device sends the first information to the second device includes: The AMF sends the first information to the second device, or the SMF sends the first information to the second device, or the SMF sends the first information to the second device via the AMF.

According to any one of the first aspect or the implementations of the first aspect, the third device includes a policy control function PCF network element, a session management function SMF network element, an access management function AMF network element, and a user plane function UPF network element.

That the third device receives the first parameter from the server includes: The PCF receives the first parameter from the server.

After the PCF receives the first parameter from the server, the method includes: The PCF sends the first parameter to the AMF, and the AMF sends the first parameter to the second device; or the PCF sends the first parameter to the SMF, and the SMF sends the first parameter to the second device; or the PCF sends the first parameter to the SMF, and the SMF sends the first parameter to the second device via the AMF.

According to any one of the first aspect or the implementations of the first aspect, the third device includes a policy control function PCF network element, a session management function SMF network element, and a user plane function UPF network element.

That the third device receives the fourth parameter from the server includes: The PCF receives the fourth parameter from the server.

After the PCF receives the fourth parameter from the server, the method includes: The PCF sends the fourth parameter to the UPF; or the PCF sends the fourth parameter to the SMF, and the SMF sends the fourth parameter to the UPF.

According to any one of the first aspect or the implementations of the first aspect,
before the third device sends the first information to the second device, the method includes: The first device, the second device, and the third device determine a first protocol data unit PDU session, where the first PDU session provides a connection between the first device and the server.

According to any one of the first aspect or the implementations of the first aspect,
the first data is first streaming media data, the second data is second streaming media data, and the third data is third streaming media data.

According to any one of the first aspect or the implementations of the first aspect, the first streaming media data is first video data, the second streaming media data is second video data, and the third streaming media data is third video data.

According to any one of the first aspect or the implementations of the first aspect, the first PDU session includes a first quality of service QoS flow, the first QoS flow corresponds to a first QoS profile, the first QoS profile includes a first QoS parameter, the first QoS parameter includes the first information, and the first data is associated with the first QoS flow.

According to any one of the first aspect or the implementations of the first aspect, the third device sends the first QoS profile to the second device.

According to any one of the first aspect or the implementations of the first aspect, the first information indicates the second device to perform joint source-channel encoding on data associated with the first QoS flow.

According to any one of the first aspect or the implementations of the first aspect, the second device sends a fifth parameter to the first device, where the fifth parameter is used by the first device to perform at least one of source decoding, channel decoding, or joint source-channel decoding on the second data, and the fifth parameter includes at least one of the following: a type of a source encoder, a coding rate in source encoding, a code length in source encoding, a base matrix in source encoding, a source entropy rate, a type of a channel encoder, a coding rate in channel encoding, a code length in channel encoding, or a base matrix in channel encoding.

According to any one of the first aspect or the implementations of the first aspect, the first device performs at least one of source decoding, channel decoding, or joint source-channel decoding on the second data based on the fifth parameter.

According to a second aspect, a communication method is provided, where the method is applied to a second device, and includes:
receiving first information from a third device, where the first information indicates the second device to perform joint source-channel encoding;
receiving first data from the third device; and
performing joint source-channel encoding on the first data, and sending second data to a first device, where the second data is data obtained by performing joint source-channel encoding on the first data.

According to the second aspect, before performing joint source-channel encoding on the first data, the method further includes:
determining a third parameter based on at least one of a first parameter and a second parameter, where the third parameter is used by the second device to perform joint source-channel encoding on the first data, where
the first parameter includes at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder; and
the second parameter indicates channel quality information between the second device and the first device; and
performing, by the second device, joint source-channel encoding on the first data based on the third parameter.

According to any one of the second aspect or the implementations of the second aspect,
the third parameter includes at least one of the following: a source quantization parameter, a coding rate in source encoding, a code length in source encoding, a base matrix in source encoding, a coding rate in channel encoding, a code length in channel encoding, or a base matrix in channel encoding.

According to any one of the second aspect or the implementations of the second aspect, the method further includes:
receiving the first parameter from the third device; or
receiving the second parameter from the first device.

According to any one of the second aspect or the implementations of the second aspect, before the second device receives the first information from the third device, the method further includes: The second device sends first capability information to the third device, where the first capability information indicates at least one of a joint source-channel encoding capability, a joint source-channel decoding capability, or a joint source-channel coding capability of the second device.

According to any one of the second aspect or the implementations of the second aspect, before the second device receives the first information from the third device, the method further includes: The second device sends second capability information to the third device, where the second capability information indicates at least one of a joint source-channel encoding capability, a joint source-channel decoding capability, or a joint source-channel coding capability of the first device.

According to any one of the second aspect or the implementations of the second aspect, before the second device sends the second capability information to the third device, the method further includes: The second device receives the second capability information from the first device.

According to any one of the second aspect or the implementations of the second aspect, the first capability information and the second capability information are located in different messages or in a same message.

According to any one of the second aspect or the implementations of the second aspect, receiving the first information from the third device includes: receiving the first information from an access management function AMF network element, or receiving the first information from a session management function SMF network element.

According to any one of the second aspect or the implementations of the second aspect, the method further includes:

The second device sends a fifth parameter to the first device, where the fifth parameter is used by the first device to perform at least one of source decoding, channel decoding, or joint source-channel decoding on the second data, and the fifth parameter includes at least one of the following: a type of a source encoder, a coding rate in source encoding, a code length in source encoding, a base matrix in source encoding, a source entropy rate, a type of a channel encoder, a coding rate in channel encoding, a code length in channel encoding, or a base matrix in channel encoding.

According to any one of the second aspect or the implementations of the second aspect, the first data is first streaming media data, and the second data is second streaming media data.

According to any one of the second aspect or the implementations of the second aspect, the first streaming media data is first video data, and the second streaming media data is second video data.

According to any one of the second aspect or the implementations of the second aspect, the first data is associated with a first quality of service QoS flow, the first QoS flow corresponds to a first QoS parameter, and the first QoS parameter includes the first information.

According to any one of the second aspect or the implementations of the second aspect, the first information indicates the second device to perform joint source-channel encoding on data associated with the first QoS flow.

According to any one of the second aspect or the implementations of the second aspect, the first data is associated with the first quality of service QoS flow, the first QoS flow corresponds to the first QoS parameter, the first QoS parameter includes the first information, and the first information indicates the second device to perform joint source-channel encoding on the data associated with the first QoS flow.

According to a third aspect, a communication method is provided, where the method is applied to a third device, and includes:
sending first information to a second device, where the first information indicates the second device to perform joint source-channel encoding; and
sending first data to the second device.

According to the third aspect, before sending the first data to the second device, the method further includes: receiving third data from a server, where the third data associated with the first data.

According to any one of the third aspect or the implementations of the third aspect, the method further includes sending a first parameter to the second device, where the first parameter includes at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder.

According to any one of the third aspect or the implementations of the third aspect, before sending the first parameter to the second device, the method further includes:
receiving the first parameter from the server.

According to any one of the third aspect or the implementations of the third aspect, the method further includes: receiving a fourth parameter from the server, where the fourth parameter is used by the third device to perform source decoding on the third data.

After receiving the third data from the server, and before sending the first data to the second device, the method further includes:
performing source decoding on the third data based on the fourth parameter, where the first data is data obtained by performing source decoding on the third data.

According to any one of the third aspect or the implementations of the third aspect, the fourth parameter includes at least one of the following: a type of a source encoder, a code length in source encoding, a coding rate in source encoding, a source entropy rate, an encryption parameter, or a decryption parameter.

According to any one of the third aspect or the implementations of the third aspect, the first parameter and the fourth parameter are located in different messages or in a same message.

According to any one of the third aspect or the implementations of the third aspect, the third device performs source decoding on the third data at a first protocol layer, the first protocol layer is a protocol data unit PDU layer, or the first protocol layer is located below the PDU layer.

According to any one of the third aspect or the implementations of the third aspect, a packet header corresponding to the first protocol layer includes the fourth parameter.

According to any one of the third aspect or the implementations of the third aspect, before sending the first information to the second device, the method further includes: receiving first capability information from the second device, where the first capability information indicates at least one of a joint source-channel encoding capability, a joint source-channel decoding capability, or a joint source-channel coding capability of the second device.

According to any one of the third aspect or the implementations of the third aspect, before sending the first information to the second device, the method further includes: receiving second capability information from a first device, or receiving second capability information from the second device, where the second capability information indicates at least one of a joint source-channel encoding capability, a joint source-channel decoding capability, or a joint source-channel coding capability of the first device, and the first device communicates with the second device.

According to any one of the third aspect or the implementations of the third aspect, before receiving the third data from the server, the first capability information or the second capability information is sent to the server.

According to any one of the third aspect or the implementations of the third aspect, the third data is the same as the first data.

According to any one of the third aspect or the implementations of the third aspect, the third device includes a policy control function PCF network element, a session management function SMF network element, an access management function AMF network element, and a user plane function UPF network element.

Sending the first information to the second device includes: The AMF sends the first information to the second device, or the SMF sends the first information to the second device, or the SMF sends the first information to the second device via the AMF.

According to any one of the third aspect or the implementations of the third aspect, the third device includes a policy control function PCF network element, a session management function SMF network element, an access management function AMF network element, and a user plane function UPF network element.

Receiving the first parameter from the server includes: The PCF receives the first parameter from the server.

After the PCF receives the first parameter from the server, the method includes: The PCF sends the first parameter to the AMF, and the AMF sends the first parameter to the second device; or the PCF sends the first parameter to the SMF, and the SMF sends the first parameter to the second device; or the PCF sends the first parameter to the SMF, and the SMF sends the first parameter to the second device via the AMF.

According to any one of the third aspect or the implementations of the third aspect, the third device includes a policy control function PCF network element, a session management function SMF network element, and a user plane function UPF network element.

Receiving the fourth parameter from the server includes: The PCF receives the fourth parameter from the server.

After the PCF receives the fourth parameter from the server, the method includes: The PCF sends the fourth parameter to the UPF; or the PCF sends the fourth parameter to the SMF, and the SMF sends the fourth parameter to the UPF.

According to any one of the third aspect or the implementations of the third aspect, before sending the first information to the second device, the method includes: The third device, the second device, and the first device, determine a first protocol data unit PDU session, where the first PDU session provides a connection between the first device and the server, and the first device communicates with the second device.

According to any one of the third aspect or the implementations of the third aspect, the first data is first streaming media data, and the third data is third streaming media data.

According to any one of the third aspect or the implementations of the third aspect, the first streaming media data is first video data, the third streaming media data is third video data, the first parameter is a video encoder parameter, and the second parameter is a source rate or a channel rate.

According to any one of the third aspect or the implementations of the third aspect, the first data is associated with a first quality of service QoS flow, the first QoS flow corresponds to a first QoS parameter, and the first QoS parameter includes the first information.

According to any one of the third aspect or the implementations of the third aspect, the first information indicates the second device to perform joint source-channel encoding on data associated with the first QoS flow.

According to a fourth aspect, a communication method is provided, where the method is applied to a system, the system includes a first device, a second device, and a third device, and the method includes:

The third device sends a first parameter to a server, where the first parameter is used by the server to perform source encoding on first data, and the first parameter includes at least one of the following: a source quantization parameter, a coding rate in source encoding, a code length in source encoding, or a base matrix in source encoding.

The third device receives second data from the server, where the second data is data obtained by performing, by the server, source encoding on the first data based on the first parameter, and the third device sends the second data to the second device.

The second device performs channel encoding on the second data, and sends third data to the first device, where the third data is data obtained by performing channel encoding on the second data.

According to the fourth aspect, before the third device sends the first parameter to the server, the method further includes:

The second device determines the first parameter based on at least one of a second parameter and a third parameter.

The second parameter includes at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder.

The third parameter indicates channel quality information between the second device and the first device.

The second device sends the first parameter to the third device.

According to any one of the fourth aspect or the implementations of the fourth aspect, the method further includes:

The third device receives the second parameter from the server, and the second device receives the second parameter from the third device.

Alternatively, the second device receives the third parameter from the first device.

According to any one of the fourth aspect or the implementations of the fourth aspect, the method further includes:

The second device determines a fourth parameter based on at least one of the second parameter and the third parameter, where the fourth parameter includes at least one of the following: a coding rate in channel encoding, a code length in channel encoding, or a base matrix in channel encoding.

The second device performs channel encoding on the second data based on the fourth parameter.

According to any one of the fourth aspect or the implementations of the fourth aspect, before the server sends the second parameter to the second device via the third device, the method includes:

The server receives first capability information from the third device, where the first capability information indicates at least one of a joint source-channel encoding capability, a joint source-channel decoding capability, or a joint source-channel coding capability of the second device.

According to any one of the fourth aspect or the implementations of the fourth aspect, before the server sends the second parameter to the second device via the third device, the method includes:

The server receives second capability information from the third device, where the second capability information indicates at least one of a joint source-channel encoding capability, a joint source-channel decoding capability, or a joint source-channel coding capability of the first device.

According to any one of the fourth aspect or the implementations of the fourth aspect, before the server receives the first capability information from the third device, the method includes: The third device receives the first capability information from the second device.

According to any one of the fourth aspect or the implementations of the fourth aspect, before the server receives the second capability information from the third device, the method includes: The third device receives the second capability information from the second device.

According to any one of the fourth aspect or the implementations of the fourth aspect, the first capability information and the second capability information are located in different messages or in a same message.

According to any one of the fourth aspect or the implementations of the fourth aspect,
before the server sends the second parameter to the second device via the third device, the method includes: The first device, the second device, and the third device determine a first protocol data unit PDU session, where the first PDU session provides a connection between the first device and the server.

According to any one of the fourth aspect or the implementations of the fourth aspect, the first data is first streaming media data, the second data is second streaming media data, and the third data is third streaming media data.

According to any one of the fourth aspect or the implementations of the fourth aspect, the first streaming media data is first video data, the second streaming media data is second video data, and the third streaming media data is third video data.

According to any one of the fourth aspect or the implementations of the fourth aspect, the third device sends first information to the second device, where the first information indicates the second device to perform joint source-channel encoding, or the first information indicates the second device to jointly optimize a source-channel encoding parameter.

According to any one of the fourth aspect or the implementations of the fourth aspect, the first PDU session includes a first quality of service QoS flow, the first QoS flow corresponds to a first QoS profile, the first QoS profile includes a first QoS parameter, the first QoS parameter includes the first information, and the first data is associated with the first QoS flow.

According to any one of the fourth aspect or the implementations of the fourth aspect, the first information indicates the second device to perform joint source-channel encoding on data associated with the first QoS flow, or the first information indicates the second device to jointly optimize the source-channel encoding parameter on the data associated with the first QoS flow.

According to any one of the fourth aspect or the implementations of the fourth aspect, the third device sends third information to the first device, where the third information indicates the first device to perform at least one of joint source-channel encoding, joint source-channel decoding, or source encoding.

According to a fifth aspect, a communication method is provided, where the method is applied to a second device, and includes:
sending a first parameter to a third device, where the first parameter is used by a server to perform source encoding on first data, and the first parameter includes at least one of the following: a source quantization parameter, a coding rate in source encoding, a code length in source encoding, or a base matrix in source encoding;
receiving second data from the third device, where the second data is data obtained by performing, by the server, source encoding on the first data based on the first parameter; and
performing, by the second device, channel encoding on the second data, and sending third data to the first device, where the third data is data obtained by performing channel encoding on the second data.

According to the fifth aspect, before sending the first parameter to the third device, the method further includes:
determining the first parameter based on at least one of a second parameter and a third parameter, where
the second parameter includes at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder; and
the third parameter indicates channel quality information between the second device and the first device; and
sending the first parameter to the third device.

According to any one of the fifth aspect or the implementations of the fifth aspect, the method further includes:
receiving the second parameter from the third device; or
receiving the third parameter from the first device.

According to any one of the fifth aspect or the implementations of the fifth aspect, the method further includes:
sending first capability information to the third device, where the first capability information indicates at least one of a joint source-channel encoding capability, a joint source-channel decoding capability, or a joint source-channel coding capability of the second device.

According to any one of the fifth aspect or the implementations of the fifth aspect, when determining the first parameter, the second device further determines a fourth parameter.

The second device performs channel encoding on the second data based on the fourth parameter.

According to any one of the fifth aspect or the implementations of the fifth aspect, the fourth parameter includes at least one of the following: a coding rate in channel encoding, a code length in channel encoding, or a base matrix in channel encoding.

According to any one of the fifth aspect or the implementations of the fifth aspect, the first parameter is the same as the fourth parameter, and the first parameter or the fourth parameter includes at least one of the following: a source quantization parameter, a coding rate in source encoding, a code length in source encoding, a base matrix in source encoding, a coding rate in channel encoding, a code length in channel encoding, or a base matrix in channel encoding.

According to any one of the fifth aspect or the implementations of the fifth aspect, before receiving the second data from the third device, the method includes: The second device, the third device, and the first device determine a first protocol data unit PDU session, where the first PDU session provides a connection between the first device and the server.

According to any one of the fifth aspect or the implementations of the fifth aspect, the second data is second streaming media data, and the third data is third streaming media data.

According to any one of the fifth aspect or the implementations of the fifth aspect, the second streaming media data is second video data, the third streaming media data is third video data, the first parameter is a source encoding parameter, and the third parameter is a video encoder parameter.

According to any one of the fifth aspect or the implementations of the fifth aspect, the second device receives first information from the third device, where the first information indicates the second device to perform joint source-channel encoding, or the first information indicates the second device to jointly optimize a source-channel encoding parameter.

According to any one of the fifth aspect or the implementations of the fifth aspect, the first PDU session includes a first quality of service QoS flow, the first QoS flow corresponds to a first QoS profile, the first QoS profile includes a first QoS parameter, the first QoS parameter includes the first information, and the first data is associated with the first QoS flow.

According to any one of the fifth aspect or the implementations of the fifth aspect, the first information indicates the second device to perform joint source-channel encoding on data associated with the first QoS flow, or the first information indicates the second device to jointly optimize the source-channel encoding parameter on the data associated with the first QoS flow.

According to any one of the fifth aspect or the implementations of the fifth aspect, the first data is associated with the first quality of service QoS flow, the first QoS flow corresponds to the first QoS parameter, the first QoS parameter includes the first information, and the first information indicates the second device to perform joint source-channel encoding on the data associated with the first QoS flow.

According to a sixth aspect, a communication method is provided, where the method is applied to a system, the system includes a first device, a second device, and a third device, and the method includes:

The first device performs joint source-channel encoding on first data based on a second parameter to obtain second data, and the first device sends the second data to the second device.

The second device performs source-channel decoding on the second data based on the second parameter to obtain third data, and the second device sends the third data to the third device.

According to a sixth aspect, the system further includes a server, and before the first device sends the second data to the second device,
the first device sends a third parameter to the third device, where the third parameter is used by the third device to perform source encoding on the third data.

The third device performs source encoding on the third data based on the third parameter in response to receiving the third data to obtain fourth data, and sends the fourth data to the server.

According to any one of the sixth aspect or the implementations of the sixth aspect, before the first device performs joint source-channel encoding on the first data,
the first device performs source decoding on the first data.

According to any one of the sixth aspect or the implementations of the sixth aspect, the first device performs source decoding on the first data at a first protocol layer.

According to any one of the sixth aspect or the implementations of the sixth aspect, the first protocol layer is a protocol data unit PDU layer, or the first protocol layer is located below the PDU layer.

According to any one of the sixth aspect or the implementations of the sixth aspect, a packet header corresponding to the first protocol layer includes the third parameter.

According to any one of the sixth aspect or the implementations of the sixth aspect, before the first device sends the second data to the second device,
the first device sends second capability information to the third device, where the second capability information indicates at least one of a joint source-channel encoding capability, a joint source-channel decoding capability, or a joint source-channel coding capability of the first device.

According to any one of the sixth aspect or the implementations of the sixth aspect, before the first device sends the second data to the second device,
the third device sends a first parameter to the first device based on the second capability information, where the first parameter indicates the first device to perform joint source-channel encoding.

According to a seventh aspect, a communication method is provided, where the method is applied to a first device, and the method includes:
sending a second parameter to a second device, where the second parameter is used by the second device to perform source-channel decoding on second data; and
performing joint source-channel encoding on the first data to obtain the second data, and sending the second data to the second device.

According to the seventh aspect, before sending the second data to the second device,
a third parameter is sent to the third device, where the third parameter is used by the third device to perform source encoding on third data.

According to any one of the seventh aspect or the implementations of the seventh aspect, before performing joint source-channel encoding on the first data,
source decoding is performed on the first data based on the third parameter.

According to any one of the seventh aspect or the implementations of the seventh aspect, source decoding is performed on the first data at a first protocol layer.

According to any one of the seventh aspect or the implementations of the seventh aspect, the first protocol layer is a protocol data unit PDU layer, or the first protocol layer is located below the PDU layer.

According to any one of the seventh aspect or the implementations of the seventh aspect, a packet header corresponding to the first protocol layer includes the third parameter.

According to an eighth aspect, a communication apparatus is provided, including: one or more processors, where the one or more processors are coupled to one or more memories, the one or more memories are configured to store a computer program or instructions, and the one or more processors are configured to execute the computer program or the instructions stored in the one or more memories, to enable the apparatus to perform any one of the implementations of the first aspect to the fifth aspect or the implementations of the first aspect to the seventh aspect.

According to a ninth aspect, a computer-readable storage medium is provided, including a program or instructions. When the program or the instructions are run on a processor, any one of the implementations of the first aspect to the seventh aspect or the implementations of the first aspect to the fifth aspect is performed.

According to a tenth aspect, a chip is provided, where the chip includes a processor and a communication interface, the communication interface is coupled to the processor, and the processor is configured to run a computer program or instructions, to implement any one of the implementations of the first aspect to the fifth aspect or the implementations of the first aspect to the seventh aspect.

### BRIEF DESCRIPTION OF DRAWINGS

FIG. 1 is a diagram of source coding and channel coding used for video transmission;
FIG. 2 is a diagram of a joint source-channel coding method used for video transmission;
FIG. 3 is a diagram of a 5G network architecture;
FIG. 4 is a diagram of a protocol stack during wireless transmission of a video;
FIG. 5 is a schematic flowchart of joint source-channel encoding of data according to Embodiment 1 of this application;
FIG. 6 is a diagram of a data delivering procedure according to Embodiment 1 of this application;
FIG. 7 is a diagram of determining a joint source-channel coding parameter by a second device according to Embodiment 1 of this application;
FIG. 8 is a schematic flowchart of sending a first parameter according to Embodiment 1 of this application;
FIG. 9 is a diagram of performing source decoding on data by a third device according to Embodiment 1 of this application;
FIG. 10 is a diagram of indicating, by a third device, a first device to perform decoding according to Embodiment 1 of this application;
FIG. 11 is a diagram of sending capability information to a third device by a first device and a second device according to Embodiment 1 of this application;
FIG. 12 is a diagram of sending, by a second device, a decoding parameter to a first device according to Embodiment 1 of this application;
FIG. 13 is a diagram of an overall communication interaction procedure between devices according to Embodiment 1 of this application;
FIG. 14 is a diagram of a communication interaction procedure between devices according to Embodiment 2 of this application;
FIG. 15 is a diagram of an enhanced protocol stack according to Embodiment 2 of this application;
FIG. 16 is a diagram of a communication interaction procedure between devices according to Embodiment 3 of this application;
FIG. 17 is a diagram of a complete communication interaction procedure between devices according to Embodiment 3 of this application;
FIG. 18 is a diagram of a communication interaction procedure between devices according to Embodiment 4 of this application;
FIG. 19 is a diagram of indicating, by a third device, a first device to perform joint source-channel encoding on data according to Embodiment 5 of this application;
FIG. 20 is a diagram of sending a message to a first device in a scenario in which a third device includes a specific network element according to Embodiment 5 of this application; and
FIG. 21 is a diagram of a communication interaction procedure in an uplink data scenario according to Embodiment 5 of this application.

### DESCRIPTION OF EMBODIMENTS

The following further performs descriptions in detail with reference to the accompanying drawings. Although some embodiments of this application are shown in the accompanying drawings, it should be understood that this application may be implemented in various forms and should not be construed as being limited to embodiments described herein, and instead, these embodiments are provided for a more thorough and complete understanding of this application. It should be understood that the accompanying drawings and embodiments of this application are merely used as examples, but are not used to limit the protection scope of this application.

Embodiments of this application may be implemented according to any appropriate communication protocol, including but not limited to cellular communication protocols such as a 3rd generation (3rd Generation, 3G), a 4th generation (4G), a 5th generation (5G), and a 6th generation (6G), a wireless local area network communication protocol such as an Institute of Electrical and Electronics Engineers (Institute of Electrical and Electronics Engineers, IEEE) 802.11, or any other protocols currently known or developed in the future.

The technical solutions in embodiments of this application are applied to a communication system that complies with any proper communication protocol, for example, a general packet radio service (General Packet Radio Service, GPRS) system, a global system for mobile communications (Global System for Mobile Communications, GSM), an enhanced data rate for GSM evolution (Enhanced Data rate for GSM Evolution, EDGE) system, a universal mobile telecommunications system (Universal Mobile Telecommunications System, UMTS), a long term evolution (Long Term Evolution, LTE) system, a wideband code division multiple access (Wideband Code Division Multiple Access, WCDMA) system, a code division multiple access 2000 (Code Division Multiple Access, CDMA2000) system, a time division-synchronization code division multiple access (Time Division-Synchronization Code Division Multiple Access, TD-SCDMA) system, a frequency division duplex (Frequency Division Duplex, FDD) system, a time division duplex (Time Division Duplex, TDD) system, a 5th generation system or a new radio (New Radio, NR) system, or a future evolved 6th generation communication system.

Data mentioned in this application, especially data used for transmission, such as first data, second data, and third data, may also be understood as streaming media data, and further, may be audio-visual data such as a video or audio.

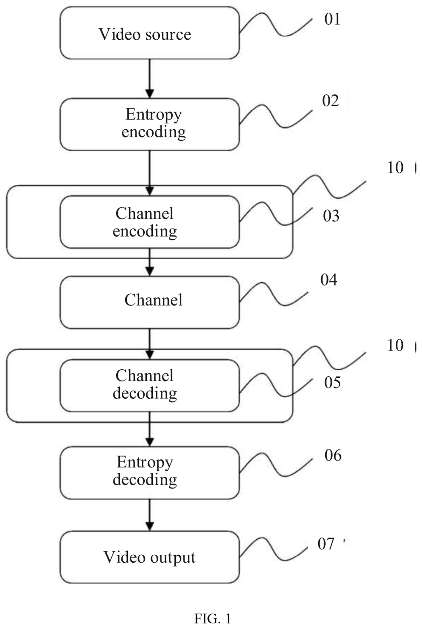

For example, FIG. 1 shows a transmission scenario. In this scenario, separate source-channel coding is used. After a step of entropy encoding 02 is performed on a data source 01, channel encoding 03 is performed at a physical layer (physical layer, PHY) 10. After the encoded data is transmitted through a channel 04, channel decoding 05 is also performed at the PHY 10, and then entropy decoding 06 is performed, to obtain a data output 07.

However, a problem of the separate source-channel coding is that data reception quality deteriorates sharply when a signal-to-noise ratio decreases.

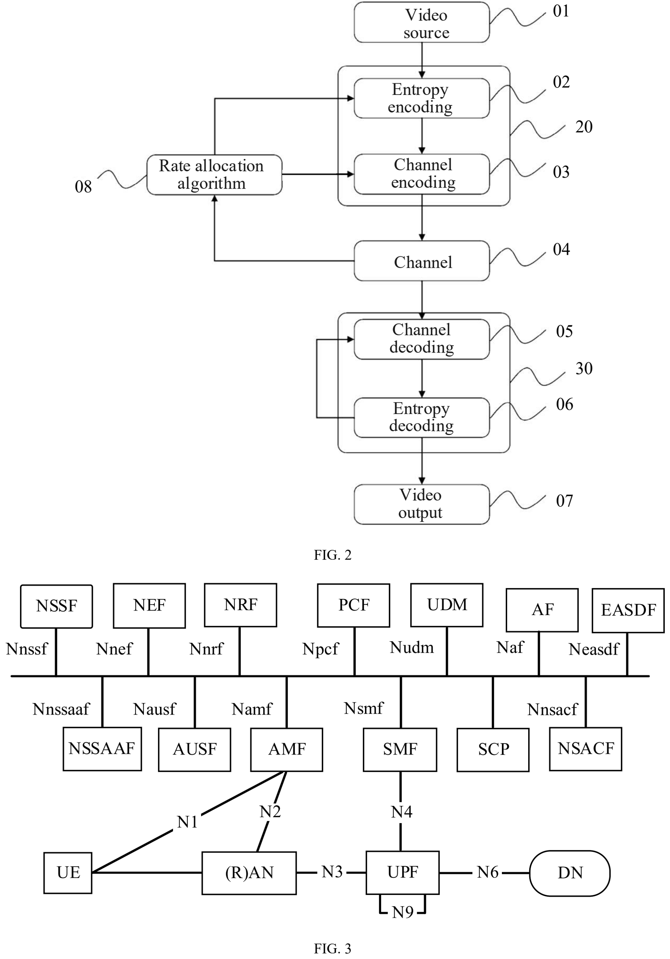

For example, FIG. 2 shows another transmission scenario. Compared with the scenario shown in FIG. 1, differences between the scenario shown in FIG. 2 and the scenario shown in FIG. 1 are as follows: A source-channel encoding parameter is obtained through joint optimization based on a rate allocation algorithm 08 and a condition of a channel 04, where the condition may be, for example, channel state information (channel state information, CSI), a channel quality indicator (channel quality indicator, CQI), or a signal-to-noise ratio (signal-to-noise ratio, SNR), or a signal to interference plus noise ratio (signal to interference plus noise ratio, SINR); and the entropy encoding 02 used for source encoding may be replaced with an encoding scheme, such as low density parity check (low density parity check, LDPC) coding or polar (Polar) coding, that is the same as the channel encoding 03. Data transmission quality can be improved by performing joint processing for a source and a channel (joint source-channel encoding 20). Correspondingly, joint processing may also be performed on the channel decoding 05 and the source entropy decoding 06 (joint source-channel decoding 30) at a receiving end. The joint source-channel processing method is referred to as joint source-channel coding. Compared with a separate coding scheme, this scheme can overcome or alleviate a cliff effect of the data reception quality caused by decrease of the signal-to-noise ratio.

Currently, it is a common phenomenon in daily life that people watch videos online through wireless transmission. For example, FIG. 3 shows a 5G system architecture in which interfaces between network elements are named in different naming manners. The 5G system architecture is a specific application scenario of embodiments of this application.

The following describes functions of network elements in this system in this application.

A 5G radio access network (radio access network, RAN) is a network that includes a plurality of 5G RAN nodes, and implements functions of a radio physical layer, resource scheduling and radio resource management, radio access control, and mobility management. The 5G RAN is connected to a user plane function (user plane function, UPF) network element through a user plane interface N3, to transfer data of UE. The RAN establishes a control plane signaling connection to an access and mobility management function (Access and Mobility Management Function, AMF) network element of a core network through a control plane interface N2, to implement functions such as radio access bearer control.

An AMF network element is mainly responsible for functions such as user equipment (user equipment, UE) authentication, UE mobility management, network slice selection, and session management function (Session Management Function, SMF) network element selection. The AMF network element serves as an anchor for N1 and N2 signaling connections, provides the SMF network element with routing of N1 and N2 session management (Session Management, SM) messages, and maintains and manages UE status information.

An SMF network element is connected to an AMF network element through an N11 interface, and is mainly responsible for all control plane functions for UE session management, including user plane function (User Plane Function, UPF) network element selection, internet protocol (Internet Protocol, IP) address allocation, quality of service (Quality of Service, QoS) attribute management of a session, obtaining a policy control and charging (Policy Control and Charging, PCC) rule from a policy control function (Policy Control Function, PCF) network element, and the like.

A PCF network element is connected to an SMF network element through an N7 interface, and connected to an AMF network element through an N15 interface. The PCF network element is configured to generate and store a PCC rule related to session management and provide the PCC rule to the SMF network element, and is further configured to generate policy information related to mobility management and provide the policy information for the AMF network element.

A UPF network element is connected to an SMF network element through an N4 interface. The UPF network element serves as an anchor of a protocol data unit (Protocol Data Unit, PDU) session connection, and is responsible for data packet filtering, data transmission or forwarding, rate control, and charging information generation of UE.

An NEF network element is a network capability exposure functional entity, and is responsible for external exposure of network capabilities. The network capabilities include a monitoring function (Monitoring capability), a provisioning capability (Provisioning capability), a policy/charging capability (Policy/Charging capability), and an analytics reporting function (Analytics reporting capability). The monitoring function (Monitoring capability) is for monitoring of specific events for UE in a 5G system. The provisioning capability (Provisioning capability) is for allowing an external party to provide information that can be used for the UE in the 5G system. The policy/charging capability (Policy/Charging capability) is for handling QoS and charging policies for the UE based on a request from the external party. The analytics reporting function (Analytics reporting capability) is for allowing the external party to obtain, or subscribe/canceling subscription to analytics information generated by the 5G system.

An AF network element is an application service functional entity, and provides data services such as videos for a user based on content from an operator network or an over-the-top (Over-the-top, OTT) service of a third-party.

It should be understood that, all the network elements shown in FIG. 3 may be independent of each other, or two or more network elements may be integrated together. This is not specifically limited in this embodiment of this application.

The UE may be a mobile phone, a tablet, customer-premises equipment (customer-premises equipment, CPE), a computer, a vehicle-mounted device, or a terminal device having a similar radio access function.

A server, or referred to as an application server, may be any platform, device, program, or the like that provides application service content or a service for a communication system in this application, for example, may be a streaming media server.

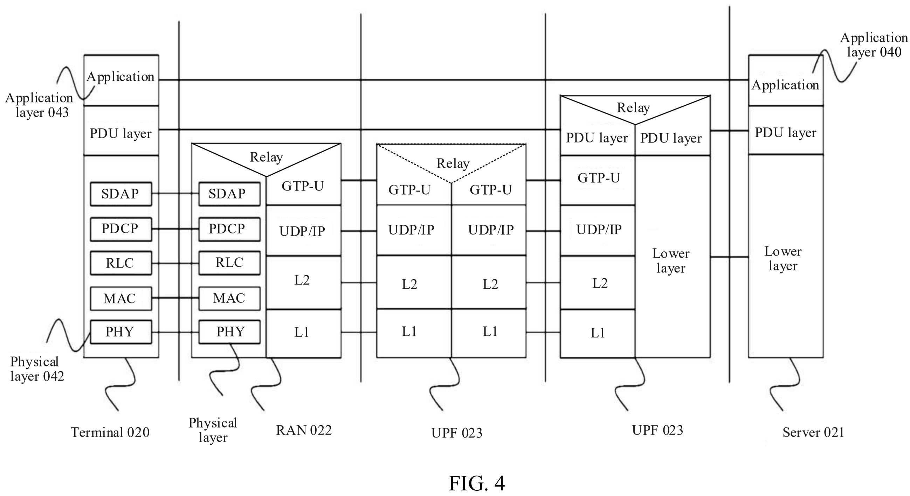

For example, FIG. 4 shows a protocol stack when data is transmitted based on the system architecture in FIG. 3.

For a downlink data transmission service, source encoding of data is performed at an application (Application) layer 040 of a server 021. A data bit stream obtained by performing source encoding on the data is transmitted to a RAN 022 via a UPF 023. A PHY 041 of the RAN 022 performs channel encoding on the data bit stream transmitted by an upper-layer protocol stack, and then transmits the data bit stream to a terminal 020 through an air interface. The terminal 020 performs channel decoding at a PHY 042, and performs source decoding at an application layer 043.

For an uplink data transmission service, similarly, source encoding of data is performed at the application layer 043 of the terminal 020, and channel encoding is performed at the PHY 042 of the terminal 020. The terminal 020 transmits, to the RAN 022 through the air interface, a data bit stream obtained by performing channel encoding on data. The RAN 022 performs channel decoding at the PHY 041, then transmits the data bit stream to the upper-layer protocol layer, and then transmits the data bit stream to the server 021 via the UPF 023. The server 021 performs source decoding at the application layer 040.

Through analysis, researchers find that, for the RAN and a third device, data at the application layer is transparently transmitted in a procedure when a data stream is transmitted in the protocol stack, and there is no interface for performing joint source-channel encoding.

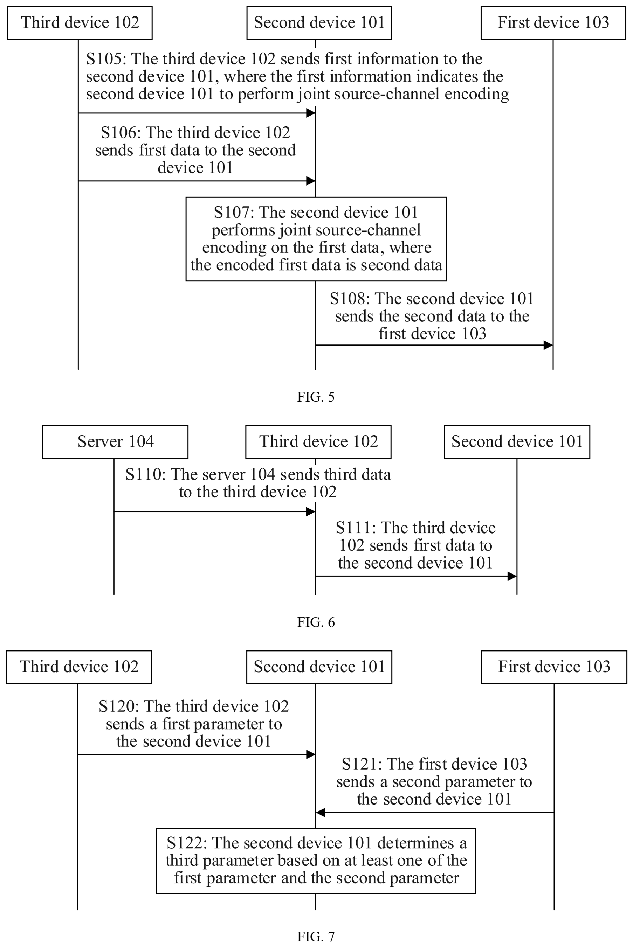

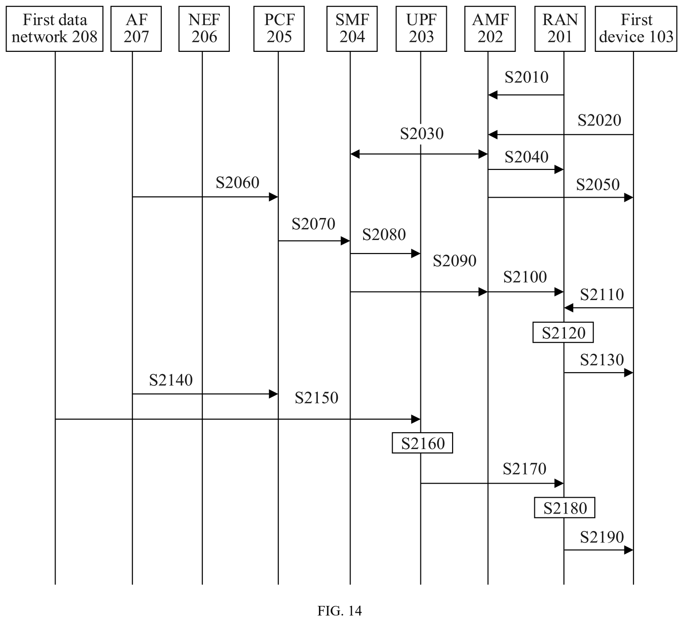

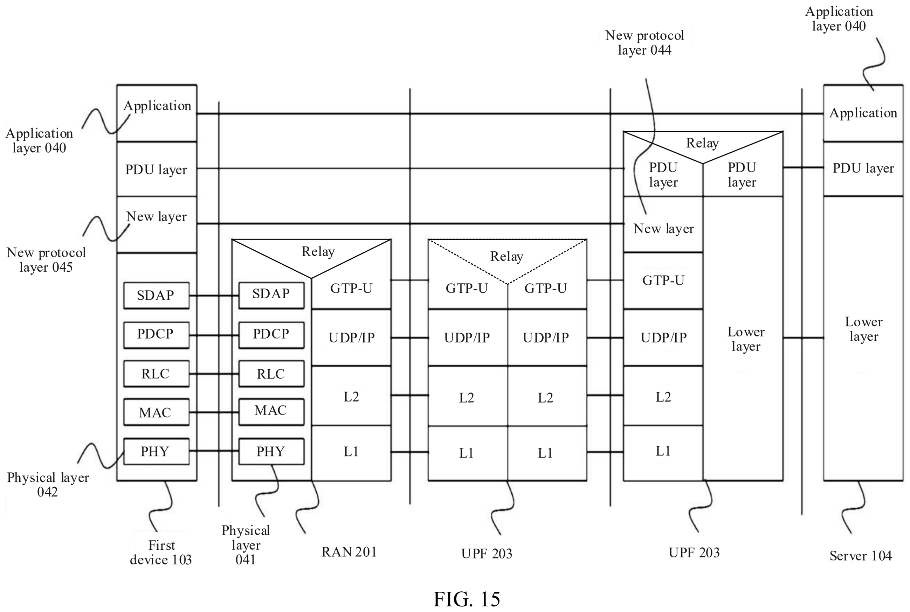

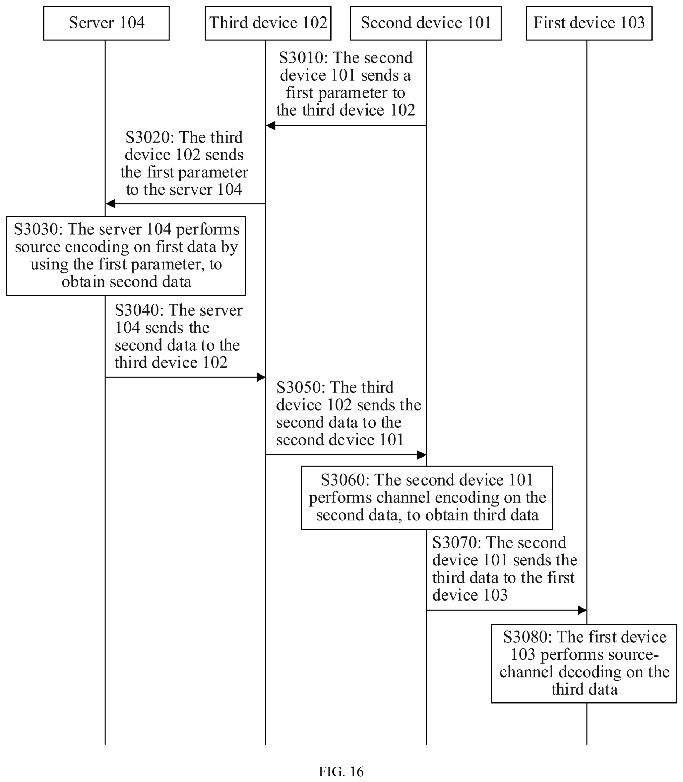

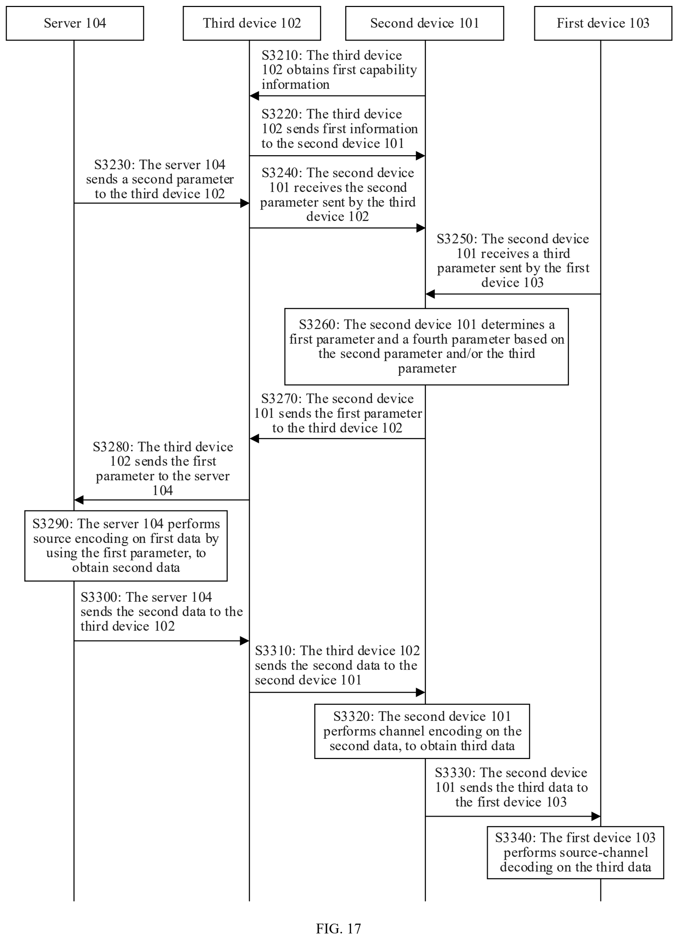

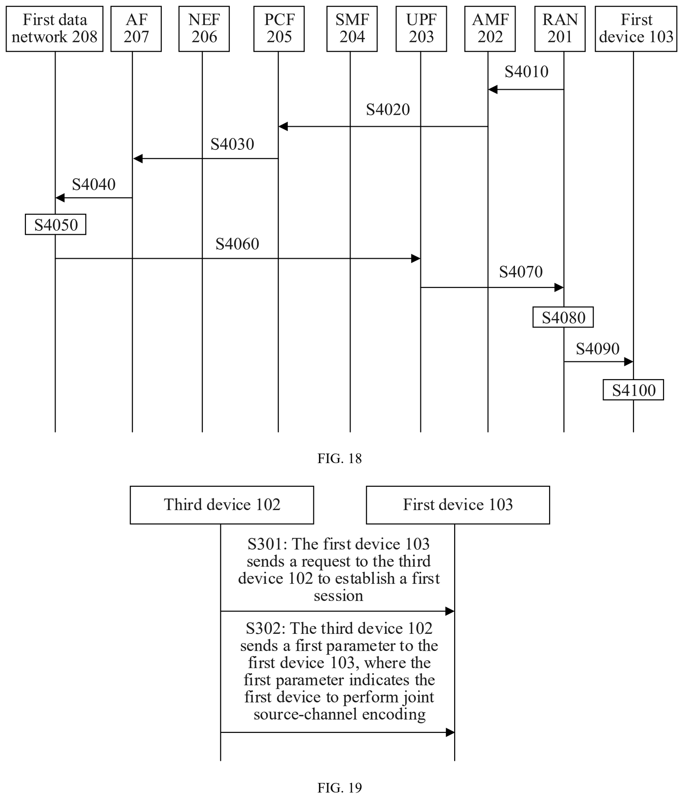

For the foregoing analyzed defects, the following specifically describes the solutions of this application by using five embodiments: Embodiment 1 to Embodiment 5, with reference to the accompanying drawings. Embodiment 1 relates to FIG. 5 to FIG. 13, Embodiment 2 relates to FIG. 14 and FIG. 15, Embodiment 3 relates to FIG. 16 and FIG. 17, Embodiment 4 relates to FIG. 18, and Embodiment 5 relates to FIG. 19 to FIG. 21. Source encoding in this application may alternatively be replaced with source entropy encoding, and source decoding may alternatively be replaced with source entropy decoding. Before data in this application is transmitted to another device, different packet headers may be added or removed, or operations such as segmentation, encryption, and decryption may be performed at different protocol layers. This is not limited in this application. For example, a core network receives first data from a server, and the core network sends first data to an access network. Although both the first data received by the core network and the first data sent by the core network are referred to as first data, different packet headers may be added to or removed from the first data at different protocol layers before the core network sends the first data to the access network. Another similar description may be understood in the same way.

### Embodiment 1

Embodiment 1 is a joint source-channel encoding method for downlink data. For example, the downlink data is data that corresponds to a video service and that is sent by a server to a terminal. The server performs source encoding on the downlink data, and then sends the data to a user plane function (User Plane Function, UPF) of a core network. The UPF performs source entropy decoding on the data sent by the server, and then sends the data to an access network (for example, a RAN, or referred to as a base station, where the RAN is used as an example for descriptions below). Optionally, the RAN may further obtain a source-channel encoding parameter through joint optimization based on a video encoder parameter delivered by the server and a channel state information parameter reported by the terminal, and the RAN performs joint source-channel encoding on corresponding data by using the parameter.

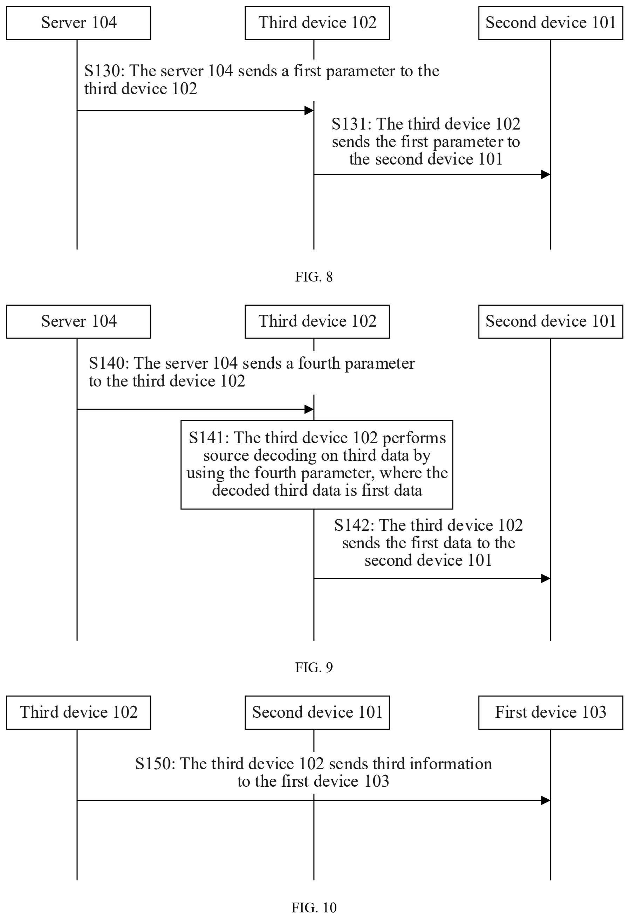

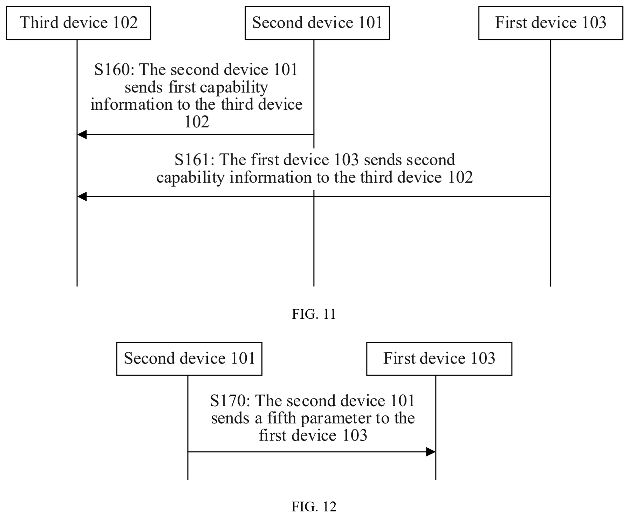

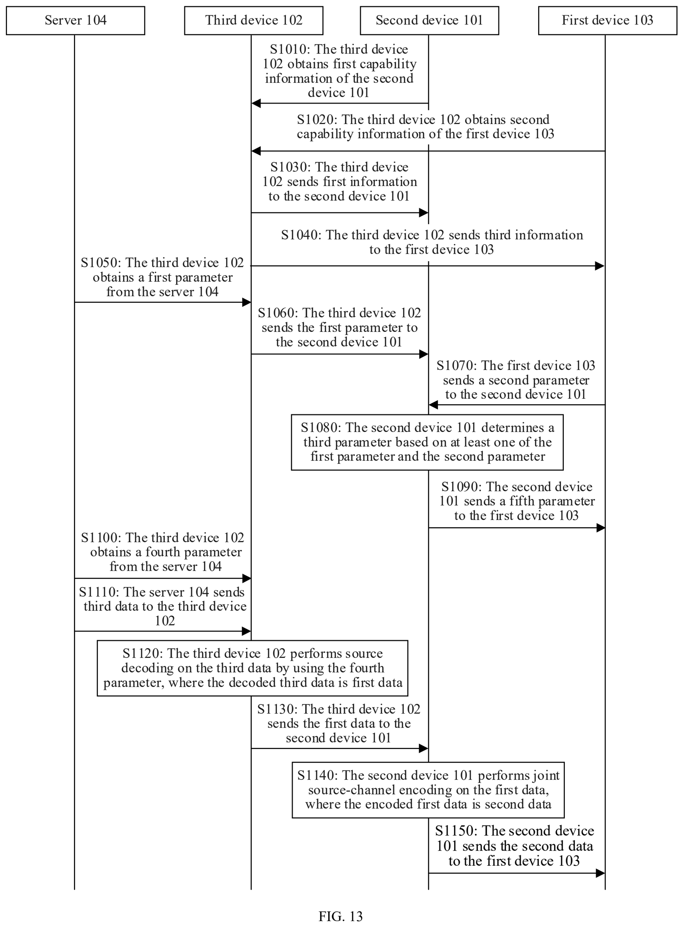

Embodiment 1 includes FIG. 5 to FIG. 13. FIG. 5 is a joint source-channel encoding procedure of data in a system. FIG. 6 is a procedure of delivering the data from a server. FIG. 7 is a procedure in which a second device 101 determines a joint source-channel encoding parameter. FIG. 8 is a procedure of sending a first parameter related to the procedure. FIG. 9 is a related procedure in which a third device 102 performs source decoding on the data. FIG. 10 shows that the third device indicates a first device to perform source-channel decoding on specified data. FIG. 11 is a procedure in which the first device 103 and the second device 101 send capability information to the third device 102. FIG. 12 is a procedure in which the second device 101 sends a joint source-channel coding parameter to the first device 103. FIG. 13 is an overall communication interaction procedure between devices according to an embodiment.

For example, the server, the first device, the second device, and the third device are used as examples to specifically describe a joint source-channel encoding method between the server, the first device, the second device, and the third device. For example, the first device is a terminal device, the second device is an access network device, and the third device is a core network device.

It should be noted that, herein, the first device, the second device, and the third device are merely used as examples for descriptions, and a joint source-channel encoding method between more devices also falls within the scope of this application.

Optionally, the server, the first device, the second device, and the third device may form a communication system.

For example, as shown in FIG. 5, the method includes the following steps.

S105: The third device 102 sends first information to the second device 101, where the first information indicates the second device 101 to perform joint source-channel encoding.

S106: The third device 102 sends first data to the second device 101.

S107: The second device 101 performs joint source-channel encoding on the first data, where the encoded first data is second data.

S108: The second device 101 sends the second data to the first device 103.

In a possible case, end-to-end data transmission between the first device and the server is associated with a first PDU session. For example, the first device may initiate a request to establish the first PDU session, or the third device may trigger the first device to initiate a request to establish the first PDU session. The first PDU session includes a first quality of service QoS flow, the first QoS flow corresponds to a first QoS profile, the first QoS profile includes a first QoS parameter, the first QoS parameter includes the first information, and the first data is associated with the first QoS flow. For example, the second device 101 is an access network device, and the third device 102 is a core network device. A UPF of the third device 102 receives a video service from the server, and the video service is mapped to the first QoS flow for transmission. A PCF of the third device 102 may generate a corresponding policy and charging control (policy and charging control, PCC) rule (PCC rule) and deliver the corresponding PCC rule to an SMF. The SMF generates a QoS parameter of the first QoS flow based on the received PCC rule, then the SMF may send a QoS profile (QoS profile) corresponding to the first QoS flow to the second device 101. The QoS profile includes the QoS parameter of the first QoS flow, the QoS parameter of the first QoS flow includes the first information, and the first information indicates the second device 101 to perform joint source-channel encoding on data associated with the first QoS flow. If receiving the first data from the third device 102 and determining that the first data is associated with the first QoS flow, the second device 101 may determine, based on the first information included in the QoS parameter of the first QoS flow, whether to perform joint source-channel encoding on the first data. For example, the second device 101 may map the first QoS flow to a first data radio bearer (data radio bearer, DRB) at a service data adaptation protocol (service data adaptation protocol, SDAP) layer. If determining to perform joint source-channel encoding on the data associated with the first QoS flow, the second device 101 may perform joint source-channel encoding on data corresponding to the first DRB at a PHY.

In a possible case, the first information may be set to "enable" ("enable") or "disable" ("disable"). When the first information is set to "enable", the second device 101 is indicated to perform joint source-channel encoding. When the first information is set to "disable", the second device 101 is indicated not to perform joint source-channel encoding. Further, the third device 102 may indicate, based on a combination of the first information and QoS flow information, the second device 101 to perform joint source-channel encoding on specific data in a QoS flow or not.

Further descriptions of S106 may be shown in FIG. 6.

S110: The server 104 sends third data to the third device 102.

S111: The third device 102 sends the first data to the second device 101.

In a possible case, the first data is associated with the third data. For example, after receiving the third data from the server and before sending the first data to the second device 101, the third device 102 performs source decoding on the third data to obtain the first data, or obtains the first data without performing source decoding on the third data.

In a possible case, the first data is the same as the third data. For example, after receiving the third data from the server and before sending the first data to the second device 101, the third device 102 obtains the first data without performing source decoding on the third data.

Further descriptions of S107 may be shown in FIG. 7.

S120: The third device 102 sends the first parameter to the second device 101.

In a possible case, the first parameter includes at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder.

S121: The first device 103 sends a second parameter to the second device 101, where the second parameter indicates channel quality information between the second device and the first device.

In a possible case, the second parameter includes at least one of the following: CSI, a CQI, an SNR, or an SINR.

S122: The second device 101 determines a third parameter based on at least one of the first parameter or the second parameter, and after receiving the first data, performs joint source-channel encoding on the first data by using the third parameter, where the encoded first data is the second data.

In a possible case, if receiving the second parameter from the first device and receiving the first parameter from the third device, the second device 101 determines the third parameter based on the first parameter and the second parameter.

In a possible case, if the second device 101 receives only one of the first parameter or the second parameter, the second device determines the third parameter based on the received parameter.

In a possible case, the second device 101 receives no first parameter or second parameter. In this case, the second device 101 uses a preconfigured third parameter, or the second device 101 determines the third parameter by itself.

In a possible case, the third parameter includes at least one of the following: a source quantization parameter, a coding rate in source encoding, a code length in source encoding, a base matrix in source encoding, a coding rate in channel encoding, a code length in channel encoding, or a base matrix in channel encoding.

For S120, optionally, as shown in FIG. 8:

S130: The server 104 sends the first parameter to the third device 102.

S131: The third device 102 sends the first parameter to the second device 101.

S130 is performed before S131. To be specific, the third device 102 first receives the first parameter from the server 104, and then sends the first parameter to the second device 101. For example, the first PDU session includes the first QoS flow, and the first PDU session is associated with a first AF session. In a process of establishing the first AF session, an AF sends the first parameter to the third device 102. For example, the AF includes the first parameter in an "Nnef_AFsessionWithQoS_Create request" message. After receiving the first parameter, the PCF of the third device 102 may generate the corresponding PCC rule and deliver the PCC rule to the SMF. The SMF generates the QoS parameter of the first QoS flow based on the received PCC rule, then the SMF may send the QoS profile (QoS profile) corresponding to the first QoS flow to the second device 101. The QoS profile includes the QoS parameter of the first QoS flow, and the QoS parameter of the first QoS flow includes the first parameter. That is, the QoS parameter of the first QoS flow may include both the first information and the first parameter.

In a possible case, S130 is performed before S106 described above.

Based on the foregoing case, optionally, when the server performs source encoding on transmitted data, there is the procedure shown in FIG. 9.

S140: The server 104 sends a fourth parameter to the third device 102.

In a possible case, the fourth parameter includes at least one of the following: a type of a source encoder, a code length in source encoding, a coding rate in source encoding, a source entropy rate, an encryption parameter, or a decryption parameter.

In a possible case, if the to-be-sent data data is not encrypted and there is no encryption requirement, the fourth parameter does not include an encryption parameter or a decryption parameter.

For example, the first PDU session includes the first QoS flow, and the first PDU session is associated with the first AF session. In the process of establishing the first AF session, the AF sends the fourth parameter to the third device 102. For example, the AF includes the fourth parameter in the "Nnef_AFsessionWithQoS_Create request" message.

S141: The third device 102 performs source decoding on the third data by using the fourth parameter, where the decoded third data is the first data.

In a possible case, the third device 102 performs source decoding on the third data at a PDU protocol layer (PDU layer).

In a possible case, the third device 102 performs source decoding on the third data at a newly added protocol layer below the PDU layer. For example, the newly added protocol layer is located between the PDU protocol layer and the SDAP protocol layer.

In a possible case, a protocol layer packet header for source decoding includes the fourth parameter. The protocol layer herein may be the PDU layer or the newly added protocol layer as described above.

In a possible case, source encoding is not performed on the third data in the server. Therefore, the third device 102 does not need to perform source decoding on the third data either. In this case, the third device only replaces a packet header necessary for the third data, so that conversion from the third data to the first data can be completed.

S142: The third device 102 sends the first data to the second device 101.

In a possible case, S140 is performed before S106 described above.

Based on the foregoing case, for example, as shown in FIG. 10:

S150: The third device 102 sends third information to the first device 103, where the third information indicates the first device to perform at least one of joint source-channel encoding, source-channel decoding, and source encoding.

In a possible case, the third device 102 sends the third information to the first device 103 via the second device 101. For example, the third device 102 sends the third information to the first device 103 via non-access stratum (non-access stratum, NAS) signaling, where the third information indicates the first device 103 to perform an operation related to source-channel decoding on the data associated with the first QoS flow. After receiving the second data, the first device 103 determines that the second data is associated with the first QoS flow. In this case, the third device 102 may perform source encoding on the second data at the PDU layer or the newly added protocol layer below the PDU layer and then transmit the second data to an application layer for source decoding at the application layer. Before performing source encoding on the second data at the PDU layer or the newly added protocol layer below the PDU layer, the third device 102 may further perform joint source-channel decoding or separate source-channel decoding on the second data at a PHY. In a possible case, S150 is performed before S106 described above.

Based on the foregoing case, for example, as shown in FIG. 11:

S160: The second device 101 sends first capability information to the third device 102, where the first capability information indicates at least one of a joint source-channel encoding capability, a joint source-channel decoding capability, or a joint source-channel coding capability of the second device 101.

In a possible case, the first capability information does not need to be sent, and the third device 102 preconfigures the capability information.

S161: The first device 103 sends second capability information to the third device 102, where the second capability information indicates at least one of a joint source-channel encoding capability, a joint source-channel decoding capability, or a joint source-channel coding capability of the first device 103.

In a possible case, the first device 103 directly sends the second capability information to the third device 102.

In a possible case, after parsing a message for the first device 103 received in S161, the second device 101 reconstructs a message and sends the message to the third device 102 in S162.

In a possible case, the second device 101 directly and transparently transmits, to the third device 102, the message for the first device 103 received in S161.

In a possible case, the third device 102 receives the information in S160 and S161 in a same message.

In a possible case, S160 to S162 are performed before S105 described above.

In a possible case, the first information in S105 described above is determined based on at least one of the first capability information and the second capability information.

In a possible case, the third information in S150 described above is determined based on at least one of the first capability information and the second capability information.

In a possible case, S160 to S162 are performed before S150 described above.

In a possible case, the third device 102 sends the first capability information or the second capability information to the server 104 before S105 described above.

In a possible case, the server 104 sends, in response to the received first capability information or second capability information, the first parameter in S130 described above or the fourth parameter in S140 described above.

Based on the foregoing case, optionally, as shown in FIG. 12:

S170: The second device 101 sends a fifth parameter to the first device 103, where the fifth parameter is used by the first device 103 to perform at least one of source decoding, channel decoding, or joint source-channel decoding on the second data, and the fifth parameter includes at least one of the following: a type of a source encoder, a coding rate in source encoding, a code length in source encoding, a base matrix in source encoding, a source entropy rate, a type of a channel encoder, a coding rate in channel encoding, a code length in channel encoding, or a base matrix in channel encoding.

In a possible case, a media access control (Media Access Control, MAC) layer of the second device 101 generates one or more transport blocks (transport blocks, TB) based on the data in the first DRB. The PHY of the second device 101 performs joint source-channel encoding on the one or more TBs. Then, the one or more encoded TBs are carried in one or more physical downlink shared channels (physical downlink shared channels, PDSCHs) and sent to the first device 103. The second device 101 may send a fifth parameter corresponding to the one or more PDSCHs to the first device 103 by using radio resource controller (radio resource controller, RRC) signaling, a MAC control element (Media Access Control control element, MAC CE), or downlink control information (downlink control information, DCI), for the first device 103 to decode the TBs carried in the one or more PDSCHs.

In a possible case, S170 is performed before the second data is sent to the first device 103 in S108 described above.

For example, as shown in FIG. 13, to more intuitively understand overall interaction, a plurality of features described above are combined in the long procedure.

S1010: The third device 102 obtains the first capability information of the second device 101.

In a possible case, the first capability information does not need to be sent, and the third device 102 preconfigures the capability information.

S1020: The third device 102 obtains the second capability information of the first device 103.

In a possible case, the second capability information is included in a PDU session establishment request message sent by the first device 103.

In a possible case, the first PDU session includes the first quality of service QoS flow, the first QoS flow corresponds to the first QoS profile, the first QoS profile includes the first QoS parameter, the first QoS parameter includes the first information, and the first data is associated with the first QoS flow.

In a possible case, the first information may be set to "enable" ("enable") or "disable" ("disable"). When the first information is set to "enable", the second device 101 is indicated to perform joint source-channel encoding. When the first information is set to "disable", the second device 101 is indicated not to perform joint source-channel encoding. Further, the third device 102 may indicate, based on a combination of the first information and QoS flow information, the second device 101 to perform joint source-channel encoding on specific data in a QoS flow or not.

In a possible case, the first device 103 sends the second capability information to the third device 102 via the second device 101.

S1030: The third device 102 sends the first information to the second device 101, where the first information indicates the second device 101 to perform joint source-channel encoding.

In a possible case, the first information in S105 described above is determined based on at least one of the first capability information and the second capability information.

S1040: The third device 102 sends the third information to the first device 103, where the third information indicates the first device to perform at least one of joint source-channel encoding, source-channel decoding, and source encoding.

In a possible case, the third information in S105 described above is determined based on at least one of the first capability information and the second capability information.

In a possible case, the third device 102 performs S1030 and S1040 by using a same message.

S1050: The third device 102 obtains the first parameter from the server 104.

In a possible case, the first parameter includes at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder.

In a possible case, before S1050, step S1050A exists: The third device 102 exposes (exposure), to the server 104, the capability information obtained in S1010 or S1020.

Based on the foregoing possible case, in a possible case, the first parameter in S1050 of the server 104 is sent in response to receiving the capability information exposed in S1050A.

In a possible case, the first parameter is sent by the server 104 to the third device 102 by using an AF session establishment related message.

S1060: The third device 102 sends the first parameter to the second device 101.

In a possible case, the first parameter includes at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder.

S1070: The first device 103 sends the second parameter to the second device 101.

In a possible case, the second parameter indicates channel state information between the first device 103 and the second device 101, and the second parameter includes at least one of the following: CSI, a CQI, an SNR, or an SINR.

In a possible case, the second parameter is reported after the second device 101 indicates the first device 103 to perform periodic or aperiodic measurement.

S1080: The second device 101 determines the third parameter based on at least one of the first parameter or the second parameter.

In a possible case, if receiving the second parameter from the first device and receiving the first parameter from the third device, the second device 101 determines the third parameter based on the first parameter and the second parameter.

In a possible case, if the second device 101 receives only one of the first parameter or the second parameter, the second device 101 can determine the third parameter based on the parameter.

In a possible case, the second device 101 receives no first parameter or second parameter. In this case, the second device 101 uses the preconfigured third parameter, or the second device 101 determines the third parameter by itself.

Based on the foregoing cases in which the second device 101 receives the parameter, in a possible case, the first device 103 and the third device 102 do not have a mechanism for sending a related parameter.

In a possible case, the third parameter includes at least one of the following: a source quantization parameter, a coding rate in source encoding, a code length in source encoding, a base matrix in source encoding, a coding rate in channel encoding, a code length in channel encoding, or a base matrix in channel encoding.

S1090: The second device 101 sends the fifth parameter to the first device 103.

In a possible case, the fifth parameter includes at least one of the following: a type of a source encoder, a coding rate in source encoding, a code length in source encoding, a base matrix in source encoding, a source entropy rate, a type of a channel encoder, a coding rate in channel encoding, a code length in channel encoding, or a base matrix in channel encoding.

In a possible case, the fifth parameter is determined based on the third parameter.

S1100: The third device 102 obtains the fourth parameter from the server 104.

In a possible case, the fourth parameter includes at least one of the following: a type of a source encoder, a code length in source encoding, a coding rate in source encoding, a source entropy rate, an encryption parameter, or a decryption parameter.

In a possible case, if to-be-sent data is not encrypted and there is no encryption requirement, the fourth parameter does not include an encryption parameter or a decryption parameter.

In an embodiment, the encryption parameter and the decryption parameter may alternatively be combined into one.

S1110: The server 104 sends the third data to the third device 102.

S1120: The third device 102 performs source decoding on the third data by using the fourth parameter, where the decoded third data is the first data.

In a possible case, the third device 102 performs source decoding on the third data at the PDU protocol layer (PDU layer).

In a possible case, the third device 102 performs source decoding on the third data at the newly added protocol layer below the PDU layer.

In a possible case, the protocol layer packet header for the source decoding includes the fourth parameter. The protocol layer herein may be the PDU layer or the newly added protocol layer as described above.

In a possible case, source encoding is not performed on the third data in the server. Therefore, the third device 102 does not need to perform source decoding on the third data either, and the third device 102 only performs processing of a packet header necessary for a corresponding protocol stack on the third data during transmission, so that conversion from the third data to the first data can be completed. In this case, from a perspective of payload of original data, the first data is the same as the third data.

S1130: The third device 102 sends the first data to the second device 101.

S1140: The second device 101 performs joint source-channel encoding on the first data by using the third parameter, where the encoded first data is the second data

S1150: The second device 101 sends the second data to the first device 103.

In the foregoing Embodiment 1, the first device 103, the second device 101, and the third device 102 may alternatively include more specific network elements, for example, an AF network element mentioned in a possibility of S1050. This application further provides detailed embodiment descriptions. The following specifically describes Embodiment 2.

### Embodiment 2

Embodiment 2 relates to FIG. 14 and FIG. 15. FIG. 14 shows a communication interaction procedure between devices in Embodiment 2. FIG. 15 shows a new protocol stack architecture in which new protocol layers are introduced into a UPF and a terminal in Embodiment 2.

For example, in comparison with Embodiment 1, a third device 102 in Embodiment 2 includes an AMF 202, a UPF 203, an SMF 204, a PCF 205, and an NEF 206. A server 104 corresponds to an AF 207 and a first data network 208, a second device 101 is represented by a RAN 201, and a first device 103 is still the first device 103.

With reference to the communication interaction procedure shown in FIG. 14, the following describes in detail a joint source-channel encoding method embodied in this embodiment.

S2010: The AMF 202 obtains first capability information of the RAN 201, where the first capability information indicates at least one of a joint source-channel encoding capability, a joint source-channel decoding capability, or a joint source-channel coding capability of the RAN 201.

In a possible case, the RAN 201 sends the first capability information of the RAN 201 when the RAN 201 establishes a link with the AMF 202 for the first time.

In a possible case, the first capability information of the RAN 201 is preconfigured on the AMF 202.

In a possible case, the AMF 202 receives the first capability information of the RAN 201 through an N2 interface.

S2020: The AMF 202 obtains second capability information of the first device 103, where the second capability information indicates at least one of a joint source-channel encoding capability, a joint source-channel decoding capability, or a joint source-channel coding capability of the first device 103.

In a possible case, the first device 103 triggers a PDU session establishment procedure, and the second capability information of the first device 103 is reported to the AMF 202 in a "PDU Session Establishment Request" message.

In a possible case, the AMF 202 receives the first capability information and the second capability information in a same message, that is, S2010 and S2020 are performed by using a same message.

S2030: The AMF 202 sends capability information to the SMF 204, and the SMF 204 sends first information or third information to the AMF 202 based on the received capability information. The first information indicates the RAN 201 to perform joint source-channel encoding, and the third information indicates the first device 103 to perform at least one of joint source-channel encoding, joint source-channel decoding, and source encoding.

In a possible case, the first information is determined by the SMF 204 based on at least one of the first capability information and the second capability information.

In a possible case, the third information is determined by the SMF 204 based on at least one of the first capability information and the second capability information.

In a possible case, the AMF 202 does not receive both the first capability information and the second capability information. In this case, the SMF 204 may deliver corresponding information based only on reported capability information, or may deliver both the first information and the third information.

S2040: The AMF 202 sends the first information to the RAN 201.

S2050: The AMF 202 sends the third information to the first device 103.

In a possible case, the AMF 202 performs S2040 and S2050 by using a same message.

S2060: The PCF 205 obtains a first parameter from the AF 207.

In a possible case, the first parameter includes at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder.

In a possible case, before S2030, step S2030A exists: The AMF 202 exposes (Exposure) the first capability information or the second capability information to the AF 207.

For example, a message used for the exposure in S2030A is a protocol message Namf_EventExposure_Notify.

In a possible case, before S2030, step S2030B exists, and S2030B and S2030A do not coexist. The first capability information or the second capability information is exposed to the AF 207 after the NEF 206 receives a message from the AMF 202.

For example, in this case, a message used for the exposure is a protocol message Nnef_EventExposure_Notify.

Based on the foregoing possible case, in another possible case, the AF 207 sends the first parameter in response to receiving the exposed capability information.

For example, in S2030B, a message used for the exposure is a protocol message Nnef_AFsessionWithQoS_Create request.

S2070: The PCF 205 sends the first parameter to the SMF 204.

S2080: The SMF 204 sends the first parameter to the UPF 203.

S2090: The SMF 204 further sends the first parameter to the AMF 202.

In a possible case, the PCF 205 directly sends the first parameter to the AMF 202, the AMF 202 then sends the first parameter to the SMF 204, and next, the SMF 204 sends the first parameter to the UPF 203.

S2100: The AMF 202 sends the first parameter to the RAN 201.

For example, the AMF 202 sends the first parameter to the RAN 201 through the N2 interface.

S2110: The first device 103 sends a second parameter to the RAN 201.

In a possible case, the second parameter indicates channel state information between the first device 103 and the RAN 201, and the second parameter includes at least one of the following: CSI, a CQI, an SNR, or an SINR.

In a possible case, the second parameter is reported after the RAN 201 indicates the first device 103 to perform periodic or aperiodic measurement.

S2120: The RAN 201 determines a third parameter based on at least one of the first parameter and the second parameter.

In a possible case, if receiving the second parameter from the first device and receiving the first parameter from the AMF 202, the RAN 201 determines the third parameter based on the first parameter and the second parameter.

In a possible case, if the RAN 201 receives only one of the first parameter or the second parameter, the RAN 201 can determine the third parameter based only on the parameter.

In a possible case, the RAN 201 receives no first parameter or second parameter. In this case, the RAN 201 uses a preconfigured third parameter, or the RAN 201 determines the third parameter by itself.

In a possible case, the third parameter includes at least one of the following: a source quantization parameter, a coding rate in source encoding, a code length in source encoding, a base matrix in source encoding, a coding rate in channel encoding, a code length in channel encoding, or a base matrix in channel encoding.

S2130: The RAN 201 sends a fifth parameter to the first device 103.

In a possible case, the fifth parameter includes at least one of the following: a type of a source encoder, a coding rate in source encoding, a code length in source encoding, a base matrix in source encoding, a source entropy rate, a type of a channel encoder, a coding rate in channel encoding, a code length in channel encoding, or a base matrix in channel encoding.

In a possible case, the fifth parameter is determined based on the third parameter.

S2140: The AF 207 sends a fourth parameter to the PCF 205.

In a possible case, in response to receiving the fourth parameter, the PCF 205 sends the fourth parameter to the SMF 204, and the SMF 204 sends the fourth parameter to the UPF 203.

In a possible case, the fourth parameter includes at least one of the following: a type of a source encoder, a code length in source encoding, a coding rate in source encoding, a source entropy rate, an encryption parameter, or a decryption parameter.

In a possible case, if to-be-sent data is not encrypted and there is no encryption requirement, the fourth parameter does not include an encryption parameter or a decryption parameter.

In a possible case, S2140 and S2060 are performed by using a same message.

S2150: The first data network 208 sends third data to the UPF 203.

S2160: The UPF 203 performs source decoding on the third data by using the fourth parameter, where the decoded third data is first data.

In a possible case, the UPF 203 performs source decoding on the third data at a PDU protocol layer (PDU layer).

In a possible case, the UPF 203 is applicable to an enhanced user plane protocol stack. As shown in FIG. 15, in a user plane protocol stack in which the UPF 203 serves as a PDU session anchor (PDU Session Anchor), a new layer: a new protocol layer 044 is added below the PDU layer. The UPF 203 performs source decoding at the new protocol layer 044. The newly added protocol layer may have another name. This is not limited in the present invention.

In a possible case, a protocol layer for source decoding is referred to as a first protocol layer, and a first protocol layer packet header includes the fourth parameter. The protocol layer herein may be the PDU layer or the newly added protocol layer as described above.

In a possible case, when the UPF 203 performs source decoding, actions to be performed include:
a: removing IP packet headers, sorting a plurality of IP packets based on IP packet header indication information, and recombining the plurality of IP packets into a complete data frame;
b: performing source decoding on a recombined data frame; and
c: dividing the data frame obtained through source decoding into the plurality of IP packets and adding IP packet headers.

In a possible case, if service data is encrypted, and the AF 207 delivers an encryption or decryption parameter in parameter real-time information of a third message, the UPF 203 performs a decryption operation when removing the IP packet headers in step a.

Based on the foregoing case, in another possible case, the UPF 203 may perform an encryption operation when adding the IP packet headers in step c. Correspondingly, the AMF 202 needs to deliver a corresponding decryption parameter to the first device 103, or the first device determines a decryption parameter based on information about the first protocol layer packet header.

In a possible case, source encoding is not performed on the third data in the server. Therefore, the UPF 203 does not need to perform source decoding on the third data either. In this case, the UPF 203 only performs processing of a packet header necessary for a corresponding protocol stack on the third data during transmission, so that conversion from the third data to the first data can be completed. In this case, from a perspective of payload of original data, the first data is the same as the third data.

S2170: The UPF 203 sends the first data to the RAN 201.

S2180: The RAN 201 performs joint source-channel encoding on the first data by using the third parameter, where the encoded first data is second data.

In a possible case, a method for the RAN 201 to perform joint source-channel encoding on the service data is as follows: With reference to the protocol stack in FIG. 15, a service data adaptation protocol (service data adaptation protocol, SDAP) layer, a packet data convergence protocol (packet data convergence protocol, PDCP) layer, a radio link control (radio link control, RLC) layer, and a media access control (Media Access Control, MAC) layer of the RAN 201 respectively add packet headers to upper-layer data, and finally, an SDAP/a PDCP/a RLC/a MAC packet header and a data part of the service data are jointly encoded at a physical layer 041.

In another possible case, the SDAP/PDCP/RLC/MAC packet header and the data part of the service data are separately transmitted or independently encoded. The RAN 201 performs joint encoding only on the data part, and performs channel encoding on the packet header part. For example, the channel encoding is performed by an LDPC channel encoding module or a polar channel encoding module.

Based on the foregoing two cases, in a possible case, the RAN 201 uses a dual-LDPC source-channel encoding module or dual-polar source-channel encoding module to perform joint source-channel encoding.

S2190: The RAN 201 sends the second data to the first device 103.

In Embodiment 2 and a further solution or an alternative solution thereof, a more specific network element architecture is introduced, to further describe implementation of the solution. With cooperation of the UPF and the RAN, an objective of performing joint source-channel encoding on downlink service data at a RAN side is achieved, and a problem of lack of a joint source-channel encoding interface in an existing protocol is resolved, so that transmission quality of downlink service data of a mobile terminal can be greatly improved.

In addition to Embodiment 1 and Embodiment 2, this application further provides another embodiment. The following describes Embodiment 3 in detail.

### Embodiment 3

In Embodiment 3, a second device 101 determines a first parameter and a fourth parameter based on a second parameter and a third parameter. For example, the first parameter is a source encoding part in an optimized joint source-channel encoding parameter, and is used by a server to perform source encoding on data. The second parameter is a related parameter used by the server to perform video encoding on a video service. The third parameter is a parameter related to channel quality information between a first device 103 and the second device 101. The fourth parameter is a channel encoding part in the optimized joint source-channel encoding parameter, and is used by the second device 101 to perform channel encoding on the data. The second device 101 sends the determined first parameter to the server 104 to perform source encoding on the data. When the data obtained through source encoding is sent to the second device 101, the second device 101 performs channel encoding on the data by using the fourth parameter, to complete joint source-channel encoding on the data. In a manner in which joint source-channel encoding actions are separately performed by the server 104 and the second device 101, computing pressure of the second device 101 can be alleviated while transmission quality of data is ensured.

FIG. 16 is mainly included, which is a related procedure in which the second device 101 sends a source encoding parameter to the server 104 and performs subsequent encoding. FIG. 17 is a complete procedure of this embodiment.

First, detailed descriptions are provided with reference to FIG. 16, as shown in the figure.

S3010: The second device 101 sends the first parameter to a third device 102.

In a possible case, for a manner of determining the first parameter, refer to a procedure of jointly optimizing a joint source-channel coding parameter by the second device 101 described in S120 to S122. The first parameter includes at least one of the following: a source quantization parameter, a coding rate in source encoding, a code length in source encoding, or a base matrix in source encoding.

Based on this case, in a possible case, the second device 101 sends, to the third device 102, a determined joint source-channel coding parameter as the first parameter.

Based on this case, in a possible case, the second device 101 sends, to the third device 102, a parameter of a source encoding part in the determined joint source-channel coding parameter as the first parameter.

S3020: The third device 102 sends the first parameter to the server 104.

S3030: The server 104 performs source encoding on first data by using the first parameter, to obtain second data.

S3040: The server 104 sends the second data to the third device 102.

S3050: The third device 102 sends the second data to the second device 101.

S3060: The second device 101 performs channel encoding on the second data by using the fourth parameter, to obtain third data.

In a possible case, the fourth parameter is the same as the first parameter.

S3070: The second device 101 sends the third data to the first device 103.

S3080: The first device 103 performs at least one of source decoding, channel decoding, or joint source-channel decoding on the third data, to finally obtain the first data.

Then, the complete procedure in FIG. 17 can be obtained, as shown in the figure.

S3210: The third device 102 obtains first capability information, where the first capability information indicates at least one of a joint source-channel encoding capability, a joint source-channel decoding capability, or a joint source-channel coding capability of the second device 101. In a possible case, the third device 102 sends the first capability information to the server 104.

S3220: The third device 102 sends first information to the second device 101, where the first information indicates the second device to perform joint source-channel encoding, or the first information indicates the second device to jointly optimize a source-channel encoding parameter.

In a possible case, the first device 103, the second device 101, and the third device 102 determine a first PDU session, where the first PDU session includes a first quality of service QoS flow, the first QoS flow corresponds to a first QoS profile, the first QoS profile includes a first QoS parameter, the first QoS parameter includes the first information, and the first data is associated with the first QoS flow. For example, the second device 101 is an access network device, and the third device 102 is a core network device. A UPF of the third device 102 receives a video service from the server, and the video service is mapped to the first QoS flow for transmission. A PCF of the third device 102 may generate a corresponding PCC rule (PCC rule) and deliver the corresponding PCC rule to an SMF. The SMF generates a QoS parameter of the first QoS flow based on the received PCC rule, then the SMF may send a QoS profile (QoS profile) corresponding to the first QoS flow to the second device 101. The QoS profile includes the QoS parameter of a first QoS flow, the QoS parameter of the first QoS flow includes the first information, and the first information indicates the second device 101 to perform joint source-channel encoding on data associated with the first QoS flow, or the first information indicates the second device 101 to jointly optimize a source-channel encoding parameter for data associated with the first QoS flow. If receiving the first data from the third device 102 and determining that the first data is associated with the first QoS flow, the second device 101 may determine, based on the first information included in the QoS parameter of the first QoS flow, whether to perform joint source-channel encoding on the first data or whether to jointly optimize the source-channel encoding parameter for the first data. For example, the second device 101 may map the first QoS flow to a first DRB at an SDAP layer. If determining to perform joint source-channel encoding on the data associated with the first QoS flow or jointly optimize the source-channel encoding parameter for the data associated with the first QoS flow, the second device 101 may perform, at a PHY based on the jointly optimized source-channel encoding parameter, channel encoding on data corresponding to the first DRB.

In a possible case, the first information may be set to "enable" ("enable") or "disable" ("disable"). When the first information is set to "enable", the second device 101 is indicated to perform joint source-channel encoding. When the first information is set to "disable", the second device 101 is indicated not to perform joint source-channel encoding. Further, the third device 102 may indicate, based on a combination of the first information and QoS flow information, the second device 101 to perform joint source-channel encoding on specific data in a QoS flow or not.

S3230: The server 104 sends the second parameter to the third device 102, where the second parameter is a related parameter used by the server to perform video encoding on a video service.

In a possible case, the server 104 sends the second parameter in response to the first capability information sent by the third device 102.

S3240: The second device 101 receives the second parameter sent by the third device 102.

In a possible case, the first PDU session includes the first QoS flow, and the first PDU session is associated with a first AF session. In a process of establishing the first AF session, an AF sends the second parameter to the third device 102. For example, the AF includes the second parameter in an "Nnef_AFsessionWithQoS_Create request" message. After receiving the second parameter, the PCF of the third device 102 may generate the corresponding PCC rule and deliver the PCC rule to the SMF. The SMF generates the QoS parameter of the first QoS flow based on the received PCC rule, then the SMF may send the QoS profile (QoS profile) corresponding to the first QoS flow to the second device 101. The QoS profile includes the QoS parameter of the first QoS flow, and the QoS parameter of the first QoS flow includes the second parameter.

S3250: The second device 101 receives the third parameter sent by the first device 103, where the third parameter is the parameter related to the channel quality information between the first device 103 and the second device 101.

S3260: The second device 101 determines the first parameter and the fourth parameter based on the second parameter and/or the third parameter.

In a possible case, the first parameter is the source encoding part in the optimized joint source-channel encoding parameter, and is used by the server to perform source encoding on the data.

In a possible case, the fourth parameter is the channel encoding part in the optimized joint source-channel encoding parameter, and is used by the second device 101 to perform channel encoding on the data.

In a possible case, the first parameter is the same as the fourth parameter.

In a possible case, all the foregoing steps are optional.

S3270: The second device 101 sends the first parameter to the third device 102.

S3280: The third device 102 sends the first parameter to the server 104.

S3290: The server 104 performs source encoding on the first data by using the first parameter, to obtain the second data.

S3300: The server 104 sends the second data to the third device 102.

S3310: The third device 102 sends the second data to the second device 101.

S3320: The second device 101 performs channel encoding on the second data by using the fourth parameter, to obtain the third data.

S3330: The second device 101 sends the third data to the first device 103.

S3340: The first device 103 performs source-channel decoding on the third data.

In the foregoing procedure, the wireless device collects channel state information of the terminal, and determines the first parameter and the fourth parameter. The server performs source encoding on the data in advance based on the first parameter, and the network device does not perform additional processing. The wireless device performs channel encoding on the data based on the fourth parameter. Joint source-channel encoding of the data is completed by different separate devices. In addition to achieving an objective of finally improving quality of receiving data by the terminal, computing pressure of the wireless device is further alleviated.

In addition to Embodiment 1, Embodiment 2, and Embodiment 3, this application further provides another embodiment. The following describes Embodiment 4 in detail.

### Embodiment 4

Embodiment 4 relates to FIG. 18, and shows a communication interaction procedure between devices in Embodiment 4.

In Embodiment 4, in comparison with Embodiment 3, a third device 102 includes an AMF 202, UPF 203, an SMF 204, a PCF 205 and an NEF 206. A server 104 corresponds to an AF 207 and a first data network 208, a second device 101 includes a RAN 201, and a first device 103 is still the first device 103. It is equivalent to a more specific network element composition manner.

With reference to the communication interaction procedure shown in FIG. 18, the following describes in detail the method embodied in this embodiment.

S4010: The RAN 201 sends a first parameter to the AMF 202.

For example, the RAN 201 sends the first parameter to the AMF 202 through an N2 interface.

In a possible case, for a manner of determining the first parameter, refer to a procedure in which the second device 101 determines a third parameter described in S120 to S122. The first parameter includes at least one of the following: a source quantization parameter, a coding rate in source encoding, a code length in source encoding, or a base matrix in source encoding.

In a possible case, when determining the first parameter, the RAN 201 further determines a fourth parameter. The fourth parameter includes at least one of the following: a coding rate in channel encoding, a code length in channel encoding, or a base matrix in channel encoding.

In a possible case, the first parameter sent by the RAN 201 includes only a part needed for source encoding.

In a possible case, when sending the first parameter, the RAN 201 is indicated to perform source encoding by using an LDPC code or a polar code.

S4020: The AMF 202 sends the first parameter to the PCF 205.

For example, the AMF 202 sends the first parameter to the PCF 205 through an N15 interface.

S4030: The PCF 205 sends the first parameter to the AF 207.

For example, the PCF 205 sends the first parameter to the AF 207 through an N5 interface.

In a possible case, the PCF 205 sends the first parameter to the AF 207 via the NEF 206.

S4040: The AF 207 sends the first parameter to the first data network 208.

S4050: The first data network 208 performs source encoding on first data by using the first parameter, where the first data after the source encoding is second data.

S4060: The first data network 208 sends the second data to the UPF 203.

For example, the first data network 208 sends the second data to the UPF 203 through an N6 interface.

S4070: The UPF 203 sends the second data to the RAN 201.

For example, the UPF 203 sends the second data to the RAN 201 through an N3 interface.

S4080: The RAN 201 performs channel encoding on the second data by using the fourth parameter, where the second data after the channel encoding is third data.

For example, the RAN 201 performs channel encoding at a PHY.

For example, the RAN 201 performs channel encoding by using an LDPC code or a polar code.

In a possible case, the RAN 201 has selected an encoding algorithm when sending a source encoding parameter in S4070.

In a possible case, the RAN 201 reads source encoding used in received service data to determine whether to specifically use the LDPC code or the polar code to perform channel encoding.

S4090: The RAN 201 sends third data to the first device 103.

S4100: The first device 103 decodes the third data, to finally obtain the first data.

In a possible case, the first device 103 performs joint source-channel decoding or separate source-channel decoding according to an encoding scheme used by the first data network 208 and the RAN 201.

Based on the foregoing case, the first device performs, at an application layer, source decoding on the service data after channel decoding, to finally obtain the first data.

In Embodiment 4 and a further solution or an alternative solution thereof, a detailed network element architecture is introduced to further describe specific implementation of another joint source-channel encoding scheme. An optimized joint source-channel encoding parameter is obtained from the RAN, and actions of source encoding and channel encoding are separately performed on the server and the RAN based on the parameter, thereby achieving an objective of performing joint source-channel encoding on downlink service data, and resolving a problem of lack of a joint source-channel encoding interface in an existing protocol. In addition, transmission quality of downlink service data of a mobile terminal can be greatly improved, and computing pressure on a wireless side is alleviated.

In addition to the foregoing Embodiments 1 to 4, this application further provides another embodiment. The following describes Embodiment 5 in detail.

### Embodiment 5

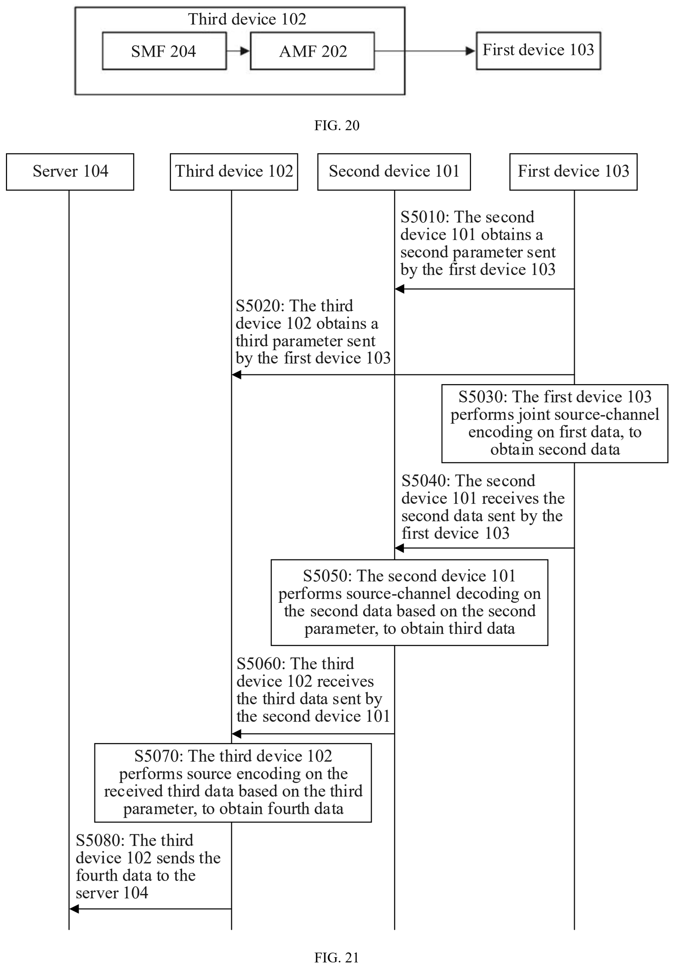

Embodiment 5 relates to FIG. 19 to FIG. 21. FIG. 19 shows an exchange procedure in which a network device indicates a terminal to perform joint source-channel encoding on uplink data in Embodiment 5. FIG. 20 shows a communication interaction procedure between devices. FIG. 21 is a diagram of sending a message to a terminal when a network device includes a possible combination of specific network elements.

Embodiment 5 describes a process in which the terminal sends data to a server, which is also referred to as a joint source-channel coding method for uplink data. Compared with the joint source-channel encoding method for downlink data described above, in this case, both source encoding and channel encoding are performed on a terminal side. Therefore, there is less signaling interaction in this scenario.

A parameter in this embodiment is independent of another embodiment, in other words, same first parameters, same second parameters, or the like have different specific meanings, and need to be understood with reference to descriptions.

First, a case in FIG. 19 is described.

S301: A first device 103 sends a request to a third device 102 to establish a first session.

S302: A third device 102 sends a first parameter to the first device 103, where the first parameter indicates the first device 103 to perform joint source-channel encoding on first data.

In a possible case, as shown in FIG. 20, the third device 102 includes an SMF 204 and an AMF 202.

Based on this case, in a possible case, the SMF 204 delivers a non-access stratum (non-access stratum, NAS) message to the first device 103 via the AMF 202 and a second device 101 (not shown in the figure), to indicate the first device 103 to perform joint source-channel encoding on the first data. The first data is data to be sent by the first device 103 to the server.

Based on this case, in a possible case, the first session is a second PDU session. For example, the second PDU session includes a second QoS flow, the first data is mapped to the second QoS flow for transmission, and the first parameter indicates the first device 103 to perform joint source-channel encoding on data associated with the second QoS flow. The NAS message delivered by the SMF 204 via the AMF 202 is a PDU session establishment accept message, the message includes an Authorized QoS rules field, the field includes a QoS rule of the second QoS flow, the QoS rule includes the first parameter, and the first parameter may be set to be enabled (enabled) or disabled (disabled). If the parameter is set to "enabled", the first device 103 determines to perform joint source-channel encoding on uplink data of the second QoS flow. If the parameter is set to "disabled", the first device 103 does not perform joint source-channel encoding on uplink data of the second QoS flow.

Based on this case, in a possible case, the first device 103 obtains the first parameter by applying reflective QoS (Reflective QoS) control, and exporting the QoS rule from downlink data that is sent by the server 104 to the first device 103 and that is obtained in a previous procedure, or from another data service. The SMF 204 does not need to additionally send a message to include the first parameter in the first device 103.

In a possible case, in S301 and S302, the first device 103 and the third device 102 send messages to each other via the second device 101.

In a possible case, in a scenario of this embodiment, before S302, optionally, the possible steps in S160, S161, and corresponding descriptions in FIG. 11 described above exist.

After a procedure of how to indicate to perform joint source-channel encoding on specific data in an uplink data scenario is understood, the following describes an overall procedure with reference to FIG. 21.

S5010: The second device 101 obtains a second parameter sent by the first device 103.

In a possible case, the second parameter is obtained by the first device 103 through joint optimization based on a video encoding parameter corresponding to the first data indicated by an application layer and channel quality measured by the first device, and is used for source-channel coding. The second parameter includes at least one of the following: a source quantization parameter, a coding rate in source encoding, a code length in source encoding, a base matrix in source encoding, a coding rate in channel encoding, a code length in channel encoding, or a base matrix in channel encoding.

S5020: The third device 102 obtains a third parameter sent by the first device 103.

In a possible case, the third parameter is used by the third device 102 to perform source encoding.

In a possible case, the third parameter includes at least one of the following: a type of a source encoder, a code length in source encoding, a coding rate in source encoding, a source entropy rate, an encryption parameter, or a decryption parameter.

Based on this case, in a possible case, if the to-be-sent data is not encrypted and there is no encryption requirement, the third parameter does not include an encryption or decryption parameter.

S5030: The first device 103 performs joint source-channel encoding on the first data, to obtain second data.

In a possible case, the first device 103 performs joint source-channel encoding on the first data at a PHY.

In a possible case, before performing the joint source-channel encoding on the first data, the first device 103 further performs source decoding on the first data.

Based on this case, in a possible case, the first data is a video service, and before performing source encoding on the first data, the first device 103 further performs video encoding on the first data at an application layer.

Based on this case, in a possible case, the first device 103 performs source decoding on the first data based on the third parameter.

Based on this case, in a possible case, the first device 103 performs source decoding on the first data at a PDU protocol layer (PDU layer).

Based on this case, in a possible case, the first device 103 performs source decoding on the first data at a newly added protocol layer below the PDU layer.

Based on this case, in a possible case, the first device 103 performs source decoding on the first data by using one of arithmetic encoding, an LDPC code, or a polar code.

Based on this case, in a possible case, data is encrypted. The first device 103 decrypts the data before the source decoding is performed, and encrypts the data after the source decoding is completed.

S5040: The second device 101 receives the second data sent by the first device 103.

S5050: The second device 101 performs joint source-channel decoding or separate source-channel decoding on the second data based on the second parameter, to obtain third data.

In a possible case, the second device 101 performs source-channel decoding at the PHY.

S5060: The third device 102 receives the third data sent by the second device 101.

S5070: The third device 102 performs source encoding on the received third data based on the third parameter, to obtain fourth data.

In a possible case, the third device 102 performs source encoding on the third data at the PDU layer or the new protocol layer below the PDU layer.

In a possible case, service data is in an encrypted state, and the third device 102 performs decryption at the PDU layer or the new protocol layer below the PDU layer.

S5080: The third device 102 sends the fourth data to the server 104.

With reference to the foregoing embodiments, by applying the method in embodiments of this application, joint source-channel coding can be performed on data during transmission, thereby improving data transmission efficiency.

Any part or all of any feature in any embodiment of this application may be freely combined. The combined technical solutions also fall within the scope of this application.

The foregoing method in embodiments of this application is applicable to a communication system. The communication system includes a server, a first device, a second device, and a third device. The server performs steps performed by a server in the foregoing method in embodiments of this application. The third device performs steps performed by a third device in the foregoing method in embodiments of this application. The second device performs steps performed by a second device in the foregoing method in embodiments of this application. The first device performs steps performed by a first device in the foregoing method in embodiments of this application.

An embodiment of this application further provides a chip. The chip may include an input interface, an output interface, and a processing circuit. In this embodiment of this application, the input interface and the output interface may be used to perform signaling interaction or data exchange related to a server, a first device, a second device, or a third device, and the processing circuit may be used to generate and process signaling or data information related to the server, the first device, the second device, or the third device.

An embodiment of this application further provides a chip system, including a processor, configured to support a computing device in implementing the function in any one of the foregoing embodiments. In a possible design, the chip system may further include a memory, configured to store necessary program instructions and data. When the processor runs the program instructions, a device in which the chip system is installed is enabled to implement the method related to a server, a first device, a second device, or a third device in any one of the foregoing embodiments. For example, the chip system may include one or more chips, or may include a chip and another discrete component.

An embodiment of this application further provides a processor, configured to be coupled to a memory. The memory stores instructions. When the processor runs the instructions, the processor is enabled to perform the method and functions related to a server, a first device, a second device, or a third device in any one of the foregoing embodiments.

An embodiment of this application further provides a computer program product including instructions. When the computer program product runs on a server, a first device, a second device, or a third device, the server, the first device, the second device, or the third device is enabled to perform the method and functions related to a server, a first device, a second device, or a third device in any one of the foregoing embodiments.

An embodiment of this application further provides a computer-readable storage medium. The computer-readable storage medium stores computer instructions. When a processor runs the instructions, the processor is enabled to perform the method and functions related to a server, a first device, a second device, or a third device in any one of the foregoing embodiments.

Usually, various embodiments of this application may be implemented by hardware or a dedicated circuit, software, logic, or any combination thereof. Some aspects may be implemented by hardware, and other aspects may be implemented by firmware or software, and may be executed by a controller, a microprocessor, or another computing device. Although aspects of embodiments of this application are shown and described as block diagrams or flowcharts, or represented by some other illustrations, it should be understood that the blocks, apparatuses, systems, technologies, or methods described in this specification may be implemented as, for example, non-limiting examples, hardware, software, firmware, dedicated circuits or logic, general-purpose hardware, controllers, other computing devices, or a combination thereof.

This application further provides at least one computer program product tangibly stored on a non-transitory computer-readable storage medium. The computer program product includes computer-executable instructions, such as instructions included in a program module, which are executed in a device on a real or virtual target processor to perform the process/method as described above with reference to the accompanying drawings. Usually, the program module includes a routine, a program, a library, an object, a class, a component, a data structure, or the like that executes a specific task or implements a specific abstract data type. In various embodiments, functions of the program modules may be combined or split between program modules as required. Machine-executable instructions for the program module may be executed locally or in a distributed device. In the distributed device, the program module may be locally located and located in a remote storage medium.

Computer program code for implementing the method in this application may be written in one or more programming languages. The computer program code may be provided for a processor of a general-purpose computer, a dedicated computer, or another programmable data processing apparatus, so that when the program code is executed by the computer or the another programmable data processing apparatus, functions/operations specified in the flowcharts and/or block diagrams are implemented. The program code may be executed entirely on a computer, partly on a computer, as a standalone software package, partly on a computer and partly on a remote computer, or entirely on a remote computer or a server.

In the context of this application, the computer program code or related data may be included in any proper carrier, so that a device, an apparatus, or a processor can perform various processing and operations described above. Examples of the carrier include a signal, a computer-readable medium, and the like. Examples of the signal may include an electrical signal, an optical signal, a radio signal, a voice signal, or other forms of propagated signals, such as a carrier wave and an infrared signal.

The computer-readable medium may be any tangible medium that includes or stores programs used for or related to an instruction execution system, an apparatus, or a device. The computer-readable medium may be a computer-readable signal medium or a computer-readable storage medium. The computer-readable medium may include but is not limited to an electronic system, a magnetic system, an optical system, an electromagnetic system, an infrared system, or a semiconductor system, an apparatus or a device, or any suitable combination thereof. More detailed examples of the computer-readable storage medium include an electrical connection with one or more wires, a portable computer disk, a hard disk drive, a random access memory (RAM), a read-only memory (ROM), an erasable programmable read-only memory (EPROM or a flash memory), an optical storage device, a magnetic storage device, or any suitable combination thereof.

In addition, although the operations of the method in this application are described in a particular order in the accompanying drawings, this does not require or imply that these operations need to be performed in the particular order or that all of the operations shown need to be performed to achieve a desired result. Instead, execution orders of the steps depicted in the flowcharts may change. Additionally or alternatively, some steps may be omitted, a plurality of steps may be combined into one step for execution, or one step may be divided into a plurality of steps for execution. It should further be noted that features and functions of two or more apparatuses according to this application may be specific in one apparatus. Instead, features and functions of one apparatus described above may be further specific in a plurality of apparatuses.

In embodiments of this application, as used in the specification and the appended claims of this application, singular expressions "a", "the", "the foregoing", "this", and "the one" also intend to include expressions such as "one or more", unless the context explicitly indicates the opposite. It should be further understood that, in the following embodiments of this application, "at least one" and "one or more" mean one or more (including two). The term "or" is used to describe an association relationship between associated objects and represents that three relationships may exist. For example, A or B may represent the following three cases: Only A exists, both A and B exist, and only B exists, where A and B may be singular or plural.

Reference to "one embodiment" or "some embodiments" described in the specification of this application means that one or more embodiments of this application include a specific feature, structure, or feature described with reference to the embodiment. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "comprise", "have", and their variants all mean "including but are not limited to", unless otherwise specifically emphasized in another manner. The term "connection" includes a direct connection and an indirect connection, unless otherwise specified. "First" and "second" are merely intended for a purpose of descriptions, and shall not be understood as an indication or implication of relative importance or implicit indication of a quantity of indicated technical features.

In embodiments of this application, the term such as "example" or "for example" is used to represent giving an example, an illustration, or a description. Any embodiment or design scheme described as an "example" or "for example" in embodiments of this application should not be construed as being more preferred or more advantageous than another embodiment or design scheme. Exactly, use of the term "example", "for example", or the like is intended to present a related concept in a specific manner.

It should be noted that, on a premise that no mutual conflict or mutual conflict is introduced, any embodiment and all or some of features in any embodiment of this application may be combined with each other, and a combined technical solution also falls within the scope of this application.

The foregoing has described the implementations of this application. The foregoing descriptions are examples, are not exhaustive, and are not limited to the disclosed implementations. Many modifications and changes are clear to a person of ordinary skill in the art without departing from the scope and spirit of the described implementations. Selection of the terms used in this specification is intended to well explain principles of the implementations, actual applications, or improvements to technologies in the market, or to enable another person of ordinary skill in the art to understand the implementations disclosed in this specification.

## Claims

1. A communication method, applied to a system, wherein the system comprises a first device, a second device, and a third device, and the method comprises:
sending, by the third device, first information to the second device, wherein the first information indicates the second device to perform joint source-channel encoding;
sending, by the third device, first data to the second device; and
performing, by the second device, joint source-channel encoding on the first data, and sending second data to the first device, wherein the second data is data obtained by performing joint source-channel encoding on the first data.

2. The method according to claim 1, wherein before sending, by the third device, the first data to the second device, the method further comprises:
receiving, by the third device, third data from a server, wherein the third data is associated with the first data.

3. The method according to claim 1 or 2, wherein before performing, by the second device, joint source-channel encoding on the first data, the method further comprises:
determining, by the second device, a third parameter based on at least one of a first parameter and a second parameter, wherein the third parameter is used by the second device to perform joint source-channel encoding on the first data, wherein
the first parameter comprises at least one of the following: a type of a source encoder, a rate-distortion mapping model of an I-frame, a rate-distortion mapping model of a P-frame, a rate-distortion mapping model of a B-frame, a size of a GOP, a type of each frame in the GOP, a quantity of slices in each frame, a length of each slice, a motion vector for predictive encoding, a source entropy rate, or processing delay information of the source encoder; and
the second parameter indicates channel quality information between the second device and the first device; and
performing, by the second device, joint source-channel encoding on the first data based on the third parameter.

4. The method according to claim 3, wherein the method further comprises:
sending, by the third device, the first parameter to the second device; or
receiving, by the second device, the second parameter from the first device.

5. The method according to any one of claims 2 to 4, wherein the method further comprises: receiving, by the third device, a fourth parameter from the server, wherein the fourth parameter is used by the third device to perform source decoding on the third data; and
after receiving, by the third device, the third data from the server, and before sending, by the third device, the first data to the second device, the method further comprises:
performing, by the third device, source decoding on the third data based on the fourth parameter, wherein the first data is data obtained by performing source decoding on the third data.

6. A communication method, applied to a second device, wherein the method comprises:
receiving first information from a third device, wherein the first information indicates the second device to perform joint source-channel encoding;
receiving first data from the third device; and
performing joint source-channel encoding on the first data, and sending second data to a first device, wherein the second data is data obtained by performing joint source-channel encoding on the first data.

7. The method according to claim 6, wherein before performing joint source-channel encoding on the first data, the method further comprises:
determining a third parameter based on at least one of a first parameter and a second parameter, wherein the third parameter is used by the second device to perform joint source-channel encoding on the first data, wherein
the first parameter comprises at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder; and
the second parameter indicates channel quality information between the second device and the first device; and
performing, by the second device, joint source-channel encoding on the first data based on the third parameter.

8. The method according to claim 7, wherein
the third parameter comprises at least one of the following: a source quantization parameter, a coding rate in source encoding, a code length in source encoding, a base matrix in source encoding, a coding rate in channel encoding, a code length in channel encoding, or a base matrix in channel encoding.

9. The method according to claim 7 or 8, wherein the method further comprises:
receiving the first parameter from the third device; or
receiving the second parameter from the first device.

10. The method according to any one of claims 6 to 9, wherein before receiving, by the second device, the first information from the third device, the method further comprises: sending, by the second device, first capability information to the third device, wherein the first capability information indicates at least one of a joint source-channel encoding capability, a joint source-channel decoding capability, or a joint source-channel coding capability of the second device.

11. The method according to any one of claims 6 to 10, wherein before receiving, by the second device, the first information from the third device, the method further comprises: sending, by the second device, second capability information to the third device, wherein the second capability information indicates at least one of a joint source-channel encoding capability, a joint source-channel decoding capability, or a joint source-channel coding capability of the first device.

12. The method according to claim 11, wherein before sending, by the second device, the second capability information to the third device, the method further comprises: receiving, by the second device, the second capability information from the first device.

13. The method according to any one of claims 6 to 12, wherein the method further comprises:
sending, by the second device, a fifth parameter to the first device, wherein the fifth parameter is used by the first device to perform at least one of source decoding, channel decoding, or joint source-channel decoding on the second data, and the fifth parameter comprises at least one of the following: a type of a source encoder, a coding rate in source encoding, a code length in source encoding, a base matrix in source encoding, a source entropy rate, a type of a channel encoder, a coding rate in channel encoding, a code length in channel encoding, or a base matrix in channel encoding.

14. The method according to any one of claims 6 to 13, wherein the first data is first streaming media data, and the second data is second streaming media data.

15. The method according to any one of claims 6 to 14, wherein the first data is associated with a first quality of service QoS flow, the first QoS flow corresponds to a first QoS parameter, and the first QoS parameter comprises the first information; and
the first information indicates the second device to perform joint source-channel encoding on data associated with the first QoS flow.

16. A communication method, applied to a third device, wherein the method comprises:
sending first information to a second device, wherein the first information indicates the second device to perform joint source-channel encoding; and
sending first data to the second device.

17. The method according to claim 16, wherein before sending the first data to the second device, the method further comprises receiving third data from a server, wherein the third data is associated with the first data.

18. The method according to claim 16 or 17, wherein the method further comprises: sending a first parameter to the second device, wherein the first parameter comprises at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder.

19. The method according to claim 18, wherein before sending the first parameter to the second device, the method further comprises:
receiving the first parameter from the server.

20. The method according to any one of claims 17 to 19, wherein the method further comprises: receiving a fourth parameter from the server, wherein the fourth parameter is used by the third device to perform source decoding on the third data; and
after receiving the third data from the server, and before sending the first data to the second device, the method further comprises:
performing source decoding on the third data based on the fourth parameter, wherein the first data is data obtained by performing source decoding on the third data.

21. The method according to claim 20, wherein the fourth parameter comprises at least one of the following: a type of a source encoder, a code length in source encoding, a coding rate in source encoding, a source entropy rate, an encryption parameter, or a decryption parameter.

22. The method according to claim 20 or 21, wherein the third device performs source decoding on the third data at a first protocol layer, the first protocol layer is a protocol data unit PDU layer, or the first protocol layer is located below the PDU layer.

23. The method according to any one of claims 16 to 22, wherein before sending the first information to the second device, the method further comprises: receiving first capability information from the second device, wherein the first capability information indicates at least one of a joint source-channel encoding capability, a joint source-channel decoding capability, or a joint source-channel coding capability of the second device.

24. The method according to any one of claims 16 to 22, wherein before sending the first information to the second device, the method further comprises: receiving second capability information from a first device, or receiving second capability information from the second device, wherein the second capability information indicates at least one of a joint source-channel encoding capability, a joint source-channel decoding capability, or a joint source-channel coding capability of the first device, and the first device communicates with the second device.

25. The method according to any one of claims 16 to 24, wherein the first data is associated with a first quality of service QoS flow, the first QoS flow corresponds to a first QoS parameter, and the first QoS parameter comprises the first information.

26. The method according to claim 25, wherein the first information indicates the second device to perform joint source-channel encoding, and the first information indicates the second device to perform joint source-channel encoding on data associated with the first QoS flow.

27. A communication method, applied to a system, wherein the system comprises a first device, a second device, and a third device, and the method comprises:
sending, by the third device, a first parameter to a server, wherein the first parameter is used by the server to perform source encoding on first data, and the first parameter comprises at least one of the following: a source quantization parameter, a coding rate in source encoding, a code length in source encoding, or a base matrix in source encoding;
receiving, by the third device, second data from the server, wherein the second data is data obtained by performing, by the server, source encoding on the first data based on the first parameter, and sending, by the third device, the second data to the second device; and
performing, by the second device, channel encoding on the second data, and sending third data to the first device, wherein the third data is data obtained by performing channel encoding on the second data.

28. The method according to claim 27, wherein before sending, by the third device, the first parameter to the server, the method further comprises:
determining, by the second device, the first parameter based on at least one of a second parameter and a third parameter, wherein
the second parameter comprises at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder; and
the third parameter indicates channel quality information between the second device and the first device; and
sending, by the second device, the first parameter to the third device.

29. The method according to claim 28, wherein the method further comprises:
receiving, by the third device, the second parameter from the server, and receiving, by the second device, the second parameter from the third device; or
receiving, by the second device, the third parameter from the first device.

30. The method according to claim 28 or 29, wherein the method further comprises:
determining, by the second device, a fourth parameter based on at least one of the second parameter and the third parameter, wherein the fourth parameter comprises at least one of the following: a coding rate in channel encoding, a code length in channel encoding, or a base matrix in channel encoding; and
performing, by the second device, channel encoding on the second data based on the fourth parameter.

31. A communication method, applied to a second device, wherein the method comprises:
sending a first parameter to a third device, wherein the first parameter is used by a server to perform source encoding on first data, and the first parameter comprises at least one of the following: a source quantization parameter, a coding rate in source encoding, a code length in source encoding, or a base matrix in source encoding;
receiving second data from the third device, wherein the second data is data obtained by performing, by the server, source encoding on the first data based on the first parameter; and
performing channel encoding on the second data, and sending third data to a first device, wherein the third data is data obtained by performing channel encoding on the second data.

32. The method according to claim 31, wherein before sending the first parameter to the third device, the method further comprises:
determining the first parameter based on at least one of a second parameter and a third parameter, wherein
the second parameter comprises at least one of the following: a type of a source encoder, a rate-distortion mapping model of an I-frame, a rate-distortion mapping model of a P-frame, a rate-distortion mapping model of a B-frame, a size of a group of pictures GOP, a type of each frame in the GOP, a quantity of slices in each frame, a length of each slice, a motion vector for predictive encoding, a source entropy rate, or processing delay information of the source encoder; and
the third parameter indicates channel quality information between the second device and the first device.

33. The method according to claim 32, wherein the method further comprises:
receiving the second parameter from the third device; or
receiving the third parameter from the first device.

34. The method according to any one of claims 31 to 33, wherein the method further comprises:
sending first capability information to the third device, wherein the first capability information indicates at least one of a joint source-channel encoding capability, a joint source-channel decoding capability, or a joint source-channel coding capability of the second device.

35. The method according to any one of claims 31 to 34, wherein the first data is associated with a first quality of service QoS flow, the first QoS flow corresponds to a first QoS parameter, the first QoS parameter comprises the first information, and the first information indicates the second device to perform joint source-channel encoding on data associated with the first QoS flow.

36. A communication apparatus, comprising one or more processors, wherein the one or more processors are coupled to one or more memories, the one or more memories are configured to store a computer program or instructions, and the one or more processors are configured to execute the computer program or the instructions stored in the one or more memories, to enable the apparatus to perform the method according to any one of claims 6 to 15, or perform the method according to any one of claims 16 to 26, or perform the method according to any one of claims 31 to 35.

37. A computer-readable storage medium, wherein the computer-readable storage medium is comprised in a second device or a third device, the computer-readable storage medium comprises a program or instructions, and when the program or the instructions are run on a processor of the second device or the third device, the second device is enabled to perform the method according to any one of claims 6 to 15 or 31 to 35, or the third device is enabled to perform the method according to any one of claims 16 to 26.

38. A chip, wherein the chip comprises a processor and a communication interface, the communication interface is coupled to the processor, the processor is configured to run a computer program or instructions, and the chip is comprised in a second device or a third device, to enable the second device to perform the method according to any one of claims 6 to 15 or claims 31 to 35, or enable the third device to perform the method according to any one of claims 16 to 26.
